# EUROPEAN PATENT APPLICATION

(11) **EP 4 529 398 A1**
(43) Date of publication of application: **26.03.2025**
(21) Application number: 24820250.9
(22) Date of filing: 21.06.2024
(51) Int. Cl.: H10K 59/122, H10K 59/12, H10K 59/121, H10K 59/80, H10K 50/80, G09F 9/33, H10K 50/19, H10K 50/18, H10K 50/17, H10K 50/16, H10K 50/15

(54) **DISPLAY PANEL, DISPLAY SCREEN AND ELECTRONIC DEVICE**

(30) Priority: 25.06.2023 CN 202310756435; 29.08.2023 CN 202311104669
(71) Applicant: Huawei Technologies Co., Ltd., Shenzhen, Guangdong 518129 (CN)
(72) Inventor: XU, Zeng, Guangdong 518129 (CN); JIANG, Zongzhao, Guangdong 518129 (CN); LUO, Jiajia, Guangdong 518129 (CN)
(74) Representative: Isarpatent
(86) International application number: PCT/CN2024/100595
(87) International publication number: WO 2025/001992

(57) **Abstract**

This application provides a display panel, a display, and an electronic device. The display panel includes a plurality of anodes, a pixel definition layer, a hole function layer, a plurality of light emitting layers, at least one organic connection layer, an electron function layer, and a cathode. Any two adjacent anodes in the plurality of anodes are isolated by the pixel definition layer. The plurality of anodes, the hole function layer, the plurality of light emitting layers, the electron function layer, and the cathode are sequentially stacked. Each organic connection layer is connected between two adjacent light emitting layers. A material of each organic connection layer includes a host material and a doped material doped in the host material, a square resistance of each organic connection layer in any horizontal direction is greater than or equal to 1 GΩ/□, and the any horizontal direction is perpendicular to a thickness direction of the organic connection layer. According to the solutions of this application, horizontal crosstalk between pixels can be reduced, and a disadvantage of a conventional partitioned tandem OLED solution can be further avoided.

## Description

This application claims priorities to Chinese Patent Application No. 202310756435.8, filed with the China National Intellectual Property Administration on June 25, 2023 and entitled "DISPLAY PANEL, DISPLAY, AND ELECTRONIC DEVICE", and to Chinese Patent Application No. 202311104669.0, filed with the China National Intellectual Property Administration on August 29, 2023 and entitled "DISPLAY PANEL, DISPLAY, AND ELECTRONIC DEVICE", both of which are incorporated herein by reference in their entireties.

### TECHNICAL FIELD

This application relates to the field of display panel technologies, and in particular, to a display panel, a display, and an electronic device.

### BACKGROUND

A tandem organic light-emitting diode (tandem organic light-emitting diode, Tandem OLED) is an OLED device structure formed by superposing a plurality of conventional OLED devices in series through a charge generation layer (charge generation layer, CGL). A display panel manufactured by using a tandem OLED technology is characterized by high luminance, low power consumption, and a long service life.

However, because the CGL is characterized by high horizontal conductivity (namely, conductivity in a direction parallel to a display panel), horizontal light emitting crosstalk between pixels occurs on a tandem OLED display panel (for example, because a red pixel is adjacent to a blue pixel, the blue pixel emits red light, leading to impurity of blue light emitted by the blue pixel). As a result, a decrease in a color gamut, color offset, and abnormal picture display occur on a screen.

### SUMMARY

Embodiments of this application provide a display panel, a display, and an electronic device, to reduce horizontal crosstalk between pixels.

According to a first aspect, an embodiment of this application provides a display panel, including a plurality of anodes, a pixel definition layer, a hole function layer, a plurality of light emitting layers, at least one organic connection layer, an electron function layer, and a cathode. Any two adjacent anodes in the plurality of anodes are isolated by the pixel definition layer. The plurality of anodes, the hole function layer, the plurality of light emitting layers, the electron function layer, and the cathode are sequentially stacked. Each organic connection layer is connected between two adjacent light emitting layers. A material of each organic connection layer includes a host material and a doped material doped in the host material, a square resistance of each organic connection layer in any horizontal direction is greater than or equal to 1 GΩ/□, and the any horizontal direction is perpendicular to a thickness direction of the organic connection layer.

In this solution, an isolation structure like an isolation groove or an isolation pillar on the PDL is canceled, so that a surface of the PDL in a region between any two anodes is continuous and has no protrusion or groove, so that the cathode can be continuously connected, a voltage drop on the cathode can be reduced, and power consumed by the cathode can be reduced. In this way, a drive voltage and power consumption of the display panel are low, and abnormal pixel lighting can be avoided. In addition, an additionally added photomask and photolithography process can be avoided. This can simplify the process and reduce costs. In addition, reliability of the display panel can be improved. Through doping modification of the organic connection layer, the organic connection layer has a high horizontal square resistance. This can greatly reduce horizontal crosstalk. Because the organic connection layer does not need to be arranged based on distribution of subpixels, and a pixel design has no impact on a design of the organic connection layer, a design for reducing horizontal crosstalk by using the organic connection layer may be applied to all tandem OLED products, so that the design is highly compatible, and can meet a mass production requirement.

In an implementation of the first aspect, the organic connection layer includes a charge generation layer, the charge generation layer includes an N-type charge generation layer and a P-type charge generation layer, and the P-type charge generation layer is stacked with the N-type charge generation layer, and is located on a side that is of the N-type charge generation layer and that faces the cathode.

In this solution, the N-type charge generation layer and the P-type charge generation layer are disposed, so that carriers can be transmitted to the two light emitting layers connected in series through the organic connection layer, to implement light emitting of a tandem OLED.

In an implementation of the first aspect, a host material of the N-type charge generation layer includes an N-type host material, a doped material of the N-type charge generation layer includes an N-type doped material, and a concentration of the N-type doped material ∈ (0%, 100%].

In this solution, a doping concentration of the N-type charge generation layer is adjusted within the range, so that a horizontal square resistance, a longitudinal mobility, and charge generation capability of the N-type charge generation layer can be comprehensively adjusted as required, to reduce horizontal crosstalk.

In an implementation of the first aspect, the N-type host material includes an organic aromatic material, and/or the N-type doped material includes a metal material whose work function is less than or equal to 3.5 eV, or a metal oxide material whose work function is less than or equal to 3.5 eV, or an organic material whose work function is less than or equal to 3.5 eV, or an organic-metal coordination compound material whose work function is less than or equal to 3.5 eV.

In this solution, the N-type host material and the N-type doped material have excellent performance, and can meet a doping modification requirement.

In an implementation of the first aspect, a host material of the P-type charge generation layer includes a P-type host material, a doped material of the P-type charge generation layer includes a P-type doped material, and a concentration of the P-type doped material ∈ (0%, 100%].

In this solution, a doping concentration of the P-type charge generation layer is adjusted within the range, so that a horizontal square resistance, a longitudinal mobility, and charge generation capability of the P-type charge generation layer can be comprehensively adjusted as required, to reduce horizontal crosstalk.

In an implementation of the first aspect, the P-type host material includes an organic aromatic material, and/or the P-type doped material includes an organic material whose lowest unoccupied molecular orbital energy level is less than or equal to -3.0 eV, or an inorganic material whose work function is greater than or equal to 3.0 eV.

In this solution, the P-type host material and the P-type doped material have excellent performance, and can meet a doping modification requirement.

In an implementation of the first aspect, the charge generation layer further includes an interlayer, and the interlayer is connected between the N-type charge generation layer and the P-type charge generation layer.

In this solution, the interlayer may implement a bridging function, to reduce a barrier between the N-type charge generation layer and the P-type charge generation layer.

In an implementation of the first aspect, the organic connection layer further includes at least one of a hole blocking layer, an electron transport layer, a hole injection layer, and a hole transport layer. The hole blocking layer, the N-type charge generation layer, and the P-type charge generation layer are sequentially stacked. The electron transport layer, the N-type charge generation layer, and the P-type charge generation layer are sequentially stacked, and when the hole blocking layer exists, the hole blocking layer, the electron transport layer, and the N-type charge generation layer are sequentially stacked. The hole injection layer is stacked with the P-type charge generation layer, and is located on a side that is of the P-type charge generation layer and that faces the cathode. The hole transport layer is stacked with the P-type charge generation layer, and is located on the side that is of the P-type charge generation layer and that faces the cathode, and when the hole injection layer exists, the P-type charge generation layer, the hole injection layer, and the hole transport layer are sequentially stacked.

In this solution, the organic connection layer further includes at least one of the hole blocking layer, the electron transport layer, the hole injection layer, and the hole transport layer, so that performance of the organic connection layer can be optimized, and generation, injection, and transmission of carriers can be ensured. This helps implement light emitting of the tandem OLED.

In an implementation of the first aspect, a longitudinal mobility of the organic connection layer is 10⁻¹ cm²/(V·S) to 10⁻⁶ cm²/(V·S).

In this solution, doping modification is performed, so that the organic connection layer can have a high longitudinal mobility. This helps reduce a drive voltage and reduce power consumption.

In an implementation of the first aspect, a thickness of each organic connection layer is less than or equal to 300 nm.

In this solution, the thickness of the organic connection layer is controlled within the range, so that the horizontal square resistance of the organic connection layer can be high. This helps reduce horizontal crosstalk.

In an implementation of the first aspect, the plurality of anodes include a first anode and a second anode. The first anode is adjacent to the second anode, and the first anode has a top surface facing the cathode. A part that is of the pixel definition layer and that is located between the first anode and the second anode has a taper angle. An acute angle formed between the top surface and a connection line between any two points on a surface that is of the cathode and that faces the pixel definition layer is less than or equal to the taper angle, and an acute angle formed between the top surface and a connection line between any two points on a surface that is of the cathode and that faces away from the pixel definition layer is less than or equal to the taper angle. According to the foregoing design, the pixel definition layer presents a flat structure in a region between any two anodes, and a surface of the region is continuous and has no protrusion or groove. There is no isolation structure on such a pixel definition layer, so that the cathode can be continuously connected, a voltage drop on the cathode can be reduced, and power consumed by the cathode can be reduced. In this way, a drive voltage and power consumption of the display panel are low, and abnormal pixel lighting can be avoided. In addition, a photomask and a photolithography process required by the isolation structure can be avoided. This can simplify the process and reduce costs. In addition, reliability of the display panel can be improved.

In an implementation of the first aspect, the display panel further includes an isolation structure. The isolation structure is formed on the pixel definition layer, and the isolation structure penetrates the hole function layer, the plurality of light emitting layers, the at least one organic connection layer, the electron function layer, and the cathode.

In this solution, the isolation structure may partially disconnect the organic connection layer from the light emitting layer in a physical partition manner, to separate subpixels of different colors in the display panel, thereby inplementing a function of reducing horizontal crosstalk. Disposing both the isolation structure and the organic connection layer with a high horizontal square resistance can enhance this function, to avoid horizontal crosstalk. This solution can meet some specific product design requirements.

In an implementation of the first aspect, the display panel includes a plurality of subpixels, some of the plurality of subpixels include a first subpixel and a second subpixel, the first subpixel is adjacent to the second subpixel, and the isolation structure is located between the first subpixel and the second subpixel. The isolation structure is disposed only between some subpixels, so that there is a small quantity of isolation structures in the display panel. This can reduce damage to the cathode, reduce power consumption of the display panel, and ensure a display effect of the display panel. In addition, it is easy to enable the isolation structure to avoid a direction and a position in which the isolation structure has poor bending reliability. This greatly improves reliability of the display panel.

In an implementation of the first aspect, the isolation structure includes a pillar structure. A process for the isolation structure with such construction is mature and reliable, and can be used to fully separate subpixels of different colors in the display panel, to meet a specific product design requirement.

In an implementation of the first aspect, the isolation structure includes a groove, and a side that is of the pixel definition layer and that faces away from the cathode is a bottom wall of the groove. A process for the isolation structure with such construction is mature and reliable, and can be used to fully separate subpixels of different colors in the display panel, to meet a specific product design requirement.

In an implementation of the first aspect, the subpixels in the display panel form a real red-green-blue arrangement, a diamond arrangement, a Delta arrangement, a tripod arrangement, a PenTile arrangement, or a diamond-like arrangement. This solution can be applied to various common pixel arrangement patterns, is highly compatible, and can meet a mass production requirement.

In an implementation of the first aspect, each light emitting layer includes a red light emitting unit, a green light emitting unit, and a blue light emitting unit.

In this solution, RGB subpixels directly emit light, so that the display panel can be colorized. A design for reducing horizontal crosstalk may be applied to a panel architecture in which the RGB subpixels directly emit light to colorize the display panel.

In an implementation of the first aspect, the display panel includes a first color filter film. The first color filter film includes a plurality of first red light filter units, a plurality of first green light filter units, and a plurality of first blue light filter units. The first color filter film is located on a side that is of the cathode and that faces away from the electron function layer, or the first color filter film is located on a side that is of the plurality of anodes and that faces away from the hole function layer. At least two of the plurality of light emitting layers are respectively configured to emit light of different colors, and the plurality of light emitting layers emit white light as a whole. The first red light filter unit is configured to filter the white light and emit red light, the first green light filter unit is configured to filter the white light and emit green light, and the first blue light filter unit is configured to filter the white light and emit blue light.

In this solution, the display panel can be colorized by using the white light + the first color filter film. A design for reducing horizontal crosstalk may be applied to a panel architecture in which the display panel is colorized by using the white light + the first color filter film.

In an implementation of the first aspect, the display panel includes a color change layer. The color change layer includes a plurality of red light conversion units and a plurality of green light conversion units, and the color change layer is located on a side that is of the cathode and that faces away from the electron function layer, or the color change layer is located on a side that is of the plurality of anodes and that faces away from the hole function layer. Each of the plurality of light emitting layers is configured to emit blue light, the red light conversion unit is configured to perform color conversion on the blue light and emit red light, and the green light conversion unit is configured to perform color conversion on the blue light and emit green light.

In this solution, the display panel may be colorized by using the blue light + the color change layer. A design for reducing horizontal crosstalk may be applied to a panel architecture in which the display panel is colorized by using the blue light + the color change layer.

In an implementation of the first aspect, the display panel further includes a second color filter film. The second color filter film is located on a side that is of the color change layer and that faces away from the cathode. The second color filter film includes a plurality of second red light filter units, a plurality of second green light filter units, and a plurality of second blue light filter units. The second red light filter unit is configured to filter the red light emitted by the red light conversion unit and emit red light, the second green light filter unit is configured to filter the green light emitted by the green light conversion unit and emit green light, and the second blue light filter unit is configured to filter the blue light and emit blue light.

In this solution, the second color filter film is added, so that a light color of the display panel can be pure.

In an implementation of the first aspect, the display panel further includes a substrate, a plurality of thin film transistors, a capping layer, and an encapsulation layer. The plurality of thin film transistors are disposed on a side that is of the substrate and that faces the plurality of anodes, and the plurality of thin film transistors are electrically connected to the plurality of anodes in a one-to-one manner, the capping layer is located on the side that is of the cathode and that faces away from the electron function layer, and the encapsulation layer is located on a side that is of the capping layer and that faces away from the cathode. The first color filter film is located on a side that is of the encapsulation layer and that faces away from the capping layer, or is located on a side that is of the substrate and that faces away from the plurality of thin film transistors. The color change layer is located on the side that is of the encapsulation layer and that faces away from the capping layer, or is located on the side that is of the substrate and that faces away from the plurality of thin film transistors. A part of the encapsulation layer is filled in the groove and covers the pixel definition layer.

In this solution, a design for reducing horizontal crosstalk may be applied to a common and typical tandem OLED panel, to reduce horizontal crosstalk of the tandem OLED panel.

According to a second aspect, an embodiment of this application provides a display, including a cover and the display panel. The cover is attached to the display panel.

The display in this solution has a display panel that can reduce horizontal crosstalk. Therefore, the display has good performance and low costs.

According to a third aspect, an embodiment of this application provides an electronic device, including a mechanical part and the display. The display is fastened to the mechanical part.

The electronic device in this solution has a display panel that can reduce horizontal crosstalk. Therefore, the electronic device has good performance and low costs.

### BRIEF DESCRIPTION OF DRAWINGS

FIG. 1 is a partial schematic top view of a conventional partitioned tandem OLED display panel;
FIG. 2 is a partial schematic sectional view along A-A in FIG. 1;
FIG. 3 is a diagram of a structure of an electronic device according to an embodiment of this application;
FIG. 4 is a diagram of a structure of another electronic device according to an embodiment of this application;
FIG. 5 is a diagram of a structure of another electronic device according to an embodiment of this application;
FIG. 6 is a diagram of a structure of another electronic device according to an embodiment of this application;
FIG. 7 is a diagram of a structure of another electronic device according to an embodiment of this application;
FIG. 8 is a diagram of a structure of another electronic device according to an embodiment of this application;
FIG. 9 is a diagram of a structure of another electronic device according to an embodiment of this application;
FIG. 10 is a diagram of a structure of another electronic device according to an embodiment of this application;
FIG. 11a is a diagram of a partial sectional structure of a display panel according to Embodiment 1;
FIG. 11b is a diagram of a flat structure presented, in a region between any two anodes, by a pixel definition layer according to Embodiment 1;
FIG. 11c is a diagram of a partial sectional structure of a display panel according to another embodiment;
FIG. 12 is a diagram of a sectional structure of an organic connection layer in FIG. 11a;
FIG. 13 is a diagram illustrating a principle of a hyper square resistance phenomenon of an organic conducting-surface;
FIG. 14 is a diagram illustrating a principle in which there is no hyper square resistance phenomenon on a metal conducting-surface;
FIG. 15 is a diagram of a principle of weakening a hyper square resistance phenomenon of an organic-inorganic hybrid conducting-surface;
FIG. 16 shows a simple connection circuit of a subpixel in the display panel in FIG. 11a;
FIG. 17 is an IV curve diagram of an OLED device;
FIG. 18 is a simulation curve indicating a relationship between a horizontal square resistance of an organic connection layer and an equivalent resistor 36R, and a lighting voltage at two ends of a light emitting unit 3c;
FIG. 19 is a diagram of a partial sectional structure of a display panel according to Embodiment 2;
FIG. 20 is a diagram of a partial sectional structure of a display panel according to Embodiment 5;
FIG. 21 is a diagram of a partial sectional structure of a display panel according to Embodiment 6;
FIG. 22 is a diagram of a partial sectional structure of a display panel in an implementation according to Embodiment 7;
FIG. 23 represents a schematic microstructure of a stack that is located between adjacent anodes and that is from an anode to a cathode in FIG. 22;
FIG. 24 is a diagram of a partial sectional structure of a display panel in another implementation according to Embodiment 7;
FIG. 25 represents a schematic microstructure of a stack that is located between adjacent anodes and that is from an anode to a cathode in FIG. 24;
FIG. 26 to FIG. 31 are diagrams of applying a horizontal crosstalk reduction design to a 2B in 1 type arrangement in a real red-green-blue arrangement according to Embodiment 7;
FIG. 32 to FIG. 37 are diagrams of applying a horizontal crosstalk reduction design to a 1B in 1 type arrangement in a real red-green-blue arrangement according to Embodiment 7;
FIG. 38 to FIG. 43 are diagrams of applying a horizontal crosstalk reduction design to a diamond arrangement according to Embodiment 7;
FIG. 44 to FIG. 47 are respectively diagrams of partial sectional structures of a display panel in different implementations according to Embodiment 8; and
FIG. 48 and FIG. 49 are diagrams of partial sectional structures of a display panel according to Embodiment 12.

### DESCRIPTION OF EMBODIMENTS

For ease of understanding, the following explains and describes related technical terms in embodiments of this application.

In the descriptions of embodiments of this application, unless otherwise specified, "a plurality of (layers)" means two (layers) or more.

Terms such as "first" and "second" are used only for description purposes, and cannot be understood as implication or implication of relative importance or an implicit indication of a quantity of indicated technical features. A feature limited by "first" or "second" may explicitly or implicitly include one or more features.

"Connection" should be understood in a broad sense. For example, "connection" may be a detachable connection or a nondetachable connection, or may be a direct connection or an indirect connection implemented through an intermediate medium. "Fastening" should also be understood in a broad sense. For example, "fastening" may be direct fastening or indirect fastening through an intermediate medium.

Orientation terms mentioned in embodiments of this application, for example, "up", "down", "top", and "bottom", are merely directions with reference to the accompanying drawings. The orientation terms are used to better and more clearly describe and understand embodiments of this application, rather than explicitly or implicitly indicating that an indicated apparatus or element needs to have a specific orientation or be constructed and operated in a specific orientation, and therefore cannot be construed as a limitation on embodiments of this application.

In the descriptions of embodiments of this application, unless otherwise specified, "and/or" is merely an association relationship for describing an associated object, and indicates that three relationships may exist. For example, A and/or B may represent the following three cases: Only A exists alone, both A and B exist, and only B exists.

In an embodiment of this application, a conventional partitioned tandem OLED solution is first described.

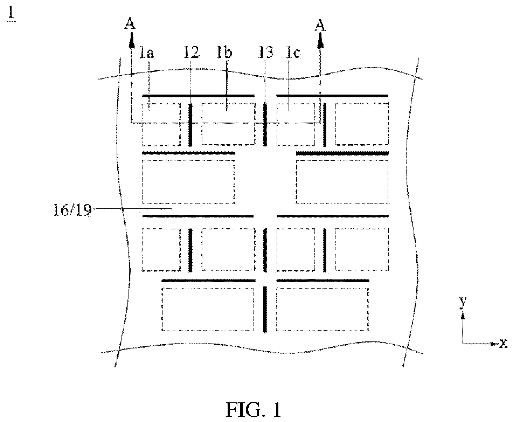

FIG. 1 is a partial schematic top view of a partitioned tandem OLED display panel (referred to as a display panel below). A line-of-sight direction is perpendicular to an xy plane, and any direction in the xy plane may be referred to as a horizontal direction.

As shown in FIG. 1, a plurality of subpixels (shown by dashed-line boxes), for example, a subpixel 1a, a subpixel 1b, and a subpixel 1c, arranged in an array are disposed on the display panel 1. An isolation pillar (shown by a black bold straight line), for example, an isolation pillar 12 or an isolation pillar 13, is basically disposed between any two adjacent subpixels. There are a large quantity of isolation pillars, and the isolation pillars are distributed at a plurality of positions in the display panel 1. These isolation pillars may be crisscrossed. Adjacent subpixels are separated by the isolation pillar, and the isolation pillar is configured to block horizontal crosstalk between the subpixels.

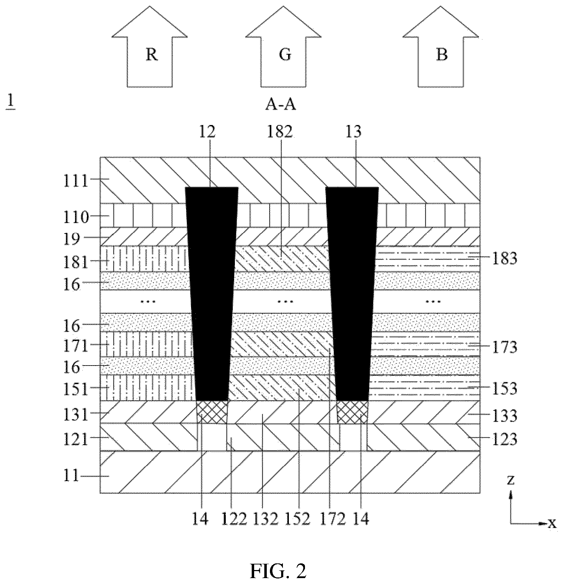

FIG. 2 is a partial schematic sectional view along A-A in FIG. 1. A line-of-sight direction is perpendicular to an xz plane, a direction along a z-axis may be referred to as a longitudinal direction, and a horizontal direction may be a direction along an x-axis.

As shown in FIG. 2, the display panel 1 may include a substrate 11, a thin film transistor (thin film transistor, TFT) 121, a TFT 122, a TFT 123, an anode 131, an anode 132, an anode 133, a pixel definition layer (pixel definition layer, PDL) 14, the isolation pillar 12, the isolation pillar 13, a light emitting unit (emitting layer, EML) 151, a light emitting unit 152, a light emitting unit 153, a plurality of CGLs 16, a light emitting unit 171, a light emitting unit 172, and a light emitting unit 173, a light emitting unit 181, a light emitting unit 182, and a light emitting unit 183, a cathode 19, and a capping layer (capping layer, CPL) 110 and an encapsulation layer 111.

Each light emitting unit participates in forming one subpixel. For example, with reference to FIG. 1 and FIG. 2, the subpixel 1a may include the light emitting unit 151, the light emitting unit 171, and the light emitting unit 181, the subpixel 1b may include the light emitting unit 152, the light emitting unit 172, and the light emitting unit 182, and the subpixel 1c may include the light emitting unit 153, the light emitting unit 173, and the light emitting unit 183. A plurality of light emitting units arranged along the z-axis can emit light of a same color. For example, the light emitting unit 151, the light emitting unit 171, and the light emitting unit 181 may emit red light. A plurality of light emitting units arranged along the x-axis may emit light of different colors. For example, the light emitting unit 151, the light emitting unit 152, and the light emitting unit 153 may emit red light, green light, and blue light respectively.

As shown in FIG. 2, one CGL 16 is disposed between every two layers of light emitting units, and every two layers of light emitting units are connected in series through the CGL 16. A quantity of layers of light emitting units connected in series may be set as required (in FIG. 2, "..." is used to represent an omitted layer of light emitting unit and CGL 16).

As shown in FIG. 2, both the isolation pillar 12 and the isolation pillar 13 are formed on the PDL 14. With reference to FIG. 2 and FIG. 1, the isolation pillar (for example, the isolation pillar 12) enables layers between the light emitting unit 151 and the capping layer 110 to be partially disconnected, and the isolation pillar separates adjacent light emitting units (for example, the light emitting unit 151 and the light emitting unit 152) at a same layer in some horizontal directions, and disconnects the plurality of CGLs 16 and the cathode 19 in the horizontal directions. With reference to FIG. 2 and FIG. 1, to ensure that the cathode 19 can operate normally, the isolation pillar does not partition the cathode 19 in all horizontal directions, in other words, the isolation pillar does not divide the cathode 19 into a plurality of mutually isolated regions, and the regions of the cathode 19 are still conducted. Correspondingly, the isolation pillar does not partition the CGL 16 in all horizontal directions, and regions of the CGL 16 are still conducted.

In the foregoing partitioned tandem OLED solution, the CGL 16 is partially disconnected in a physical partition manner, to reduce horizontal crosstalk. However, as described above, the CGL 16 is not disconnected in all the horizontal directions, and the regions of the CGL 16 are still conducted. Consequently, horizontal crosstalk may still exist. Because the cathode 19 is partially disconnected and discontinuous, surface impedance of the cathode 19 increases, a voltage drop (current and resistance drop, IR drop) on the cathode 19 increases, and power consumed by the cathode 19 increases. Consequently, a drive voltage and power consumption of the display panel 1 are high. Particularly, when there are a large quantity of isolation pillars, the cathode 19 is severely damaged, resulting in an increasingly significant disadvantage of high power consumption. In addition, the disconnection of the cathode 19 may further cause abnormal pixel lighting. In addition, additional one or two steps such as mask photoetching and photolithography need to be added to prepare the isolation pillar, and an additional process needs to be introduced. This causes an increase in costs. In addition, the display panel 1 has a reliability problem. After the display panel 1 faces a scenario like bending, long-time highlighting, or extrusion, performance of the display panel 1 is likely to deteriorate due to a failure of the isolation pillar, for example, the display panel 1 may have disadvantages such as dark spots, shading, and abnormal light emitting of pixels. In particular, when there are a large quantity of isolation pillars, the reliability disadvantage becomes increasingly significant. In addition, an isolation structure in the partitioned tandem OLED solution needs to be arranged based on distribution of subpixels. A pixel design has great impact on a design of the isolation structure, and a same design of the isolation structure cannot be directly migrated to all tandem OLED products. Consequently, the design lacks compatibility, and can hardly meet a mass production requirement.

In view of this, the following embodiments of this application provide an alternative solution to the conventional partitioned tandem OLED, to reduce or overcome the foregoing disadvantages of the conventional partitioned tandem OLED. The following provides detailed descriptions.

An embodiment of this application provides an electronic device. The electronic device includes but is not limited to a mobile phone (for example, a bar-type mobile phone, a foldable mobile phone, or a rollable-screen mobile phone), a tablet computer, a notebook computer (including a foldable notebook computer), a smart screen, a desktop computer display, a smart band, a smartwatch, a mixed reality (mixed reality, MR) device, a virtual reality (virtual reality, VR) device, an augmented reality (augmented reality, AR) device, and a vehicle-mounted device (for example, a head unit). The electronic device includes a mechanical part and a display fastened to the mechanical part. The display may include a cover and a display panel. The cover is attached to the display panel. The display panel may be a tandem OLED display panel. The following enumerates several specific forms of the electronic device.

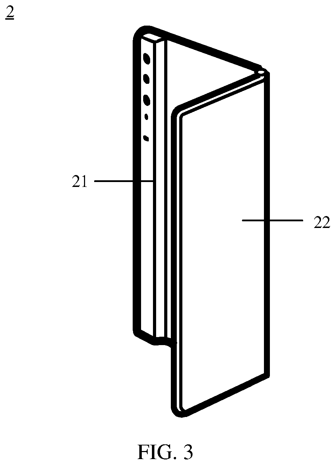

For example, as shown in FIG. 3, an electronic device 2 may be a foldable mobile phone, and the electronic device 2 may include a mechanical part 21 and a display 22 fastened to the mechanical part 21. The mechanical part 21 may include a middle frame, and the display 22 may be mounted on the middle frame. The display 22 may include a flexible cover and a display panel that are attached to each other. For example, when the electronic device 2 is folded, the display 22 may be on an outer side, and the electronic device 2 may be an outward-foldable mobile phone. In another embodiment, when the electronic device 2 is folded, the display 22 may be on an inner side, and the electronic device 2 may be an inward-foldable mobile phone.

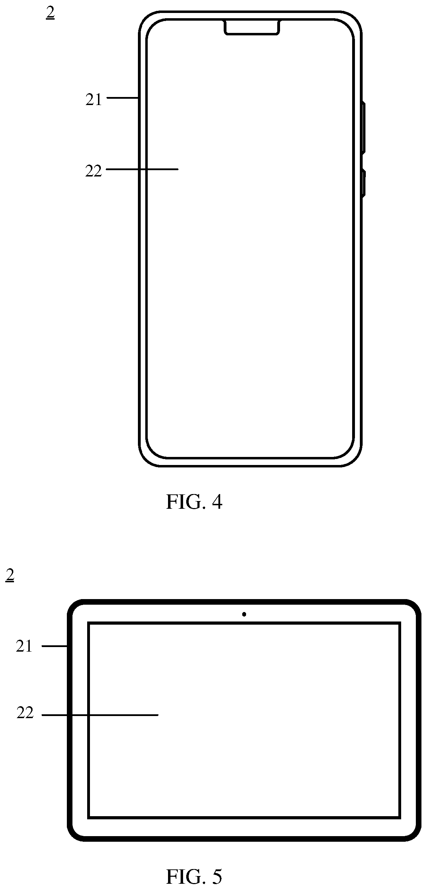

Different from that shown in FIG. 3, as shown in FIG. 4, the electronic device 2 may be a bar-type mobile phone, and the display 22 may include a rigid cover and a display panel that are attached to each other. Different from that shown in FIG. 4, as shown in FIG. 5, the electronic device 2 may be a tablet computer.

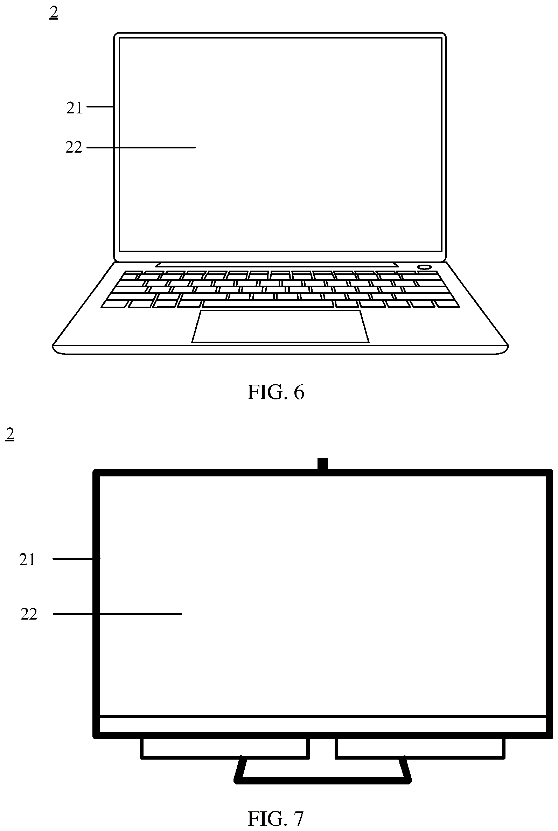

As shown in FIG. 6, the electronic device 2 may be a notebook computer, the electronic device 2 may include a screen part and a keyboard part, the mechanical part 21 may be a housing of the screen part, and the display 22 may include a rigid cover and a display panel that are attached to each other. Different from that shown in FIG. 6, as shown in FIG. 7, the electronic device 2 may be a smart screen, the mechanical part 21 may include a middle frame, and the display 22 may be mounted on the middle frame. The display 22 may include a rigid cover and a display panel that are attached to each other.

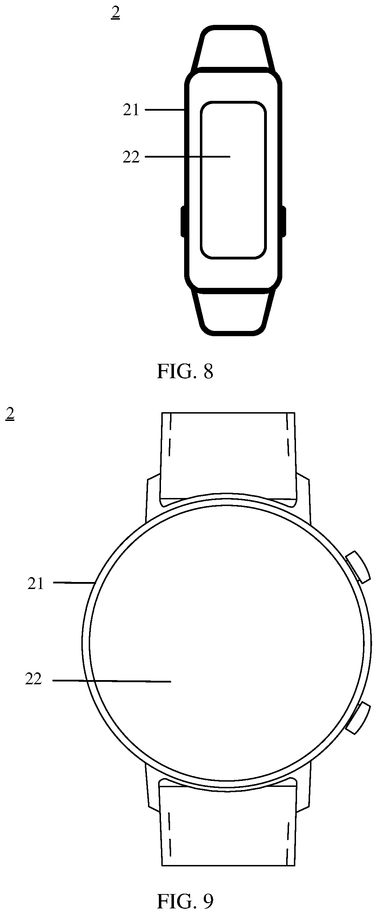

As shown in FIG. 8, the electronic device 2 may be a smart band, the mechanical part 21 may include a support, and the display 22 may be mounted on the support. The display 22 may include a rigid cover and a display panel that are attached to each other. Different from that shown in FIG. 8, as shown in FIG. 9, the electronic device 2 may be a smartwatch, the mechanical part 21 may include a watch case, and the display 22 may be mounted on the watch case.

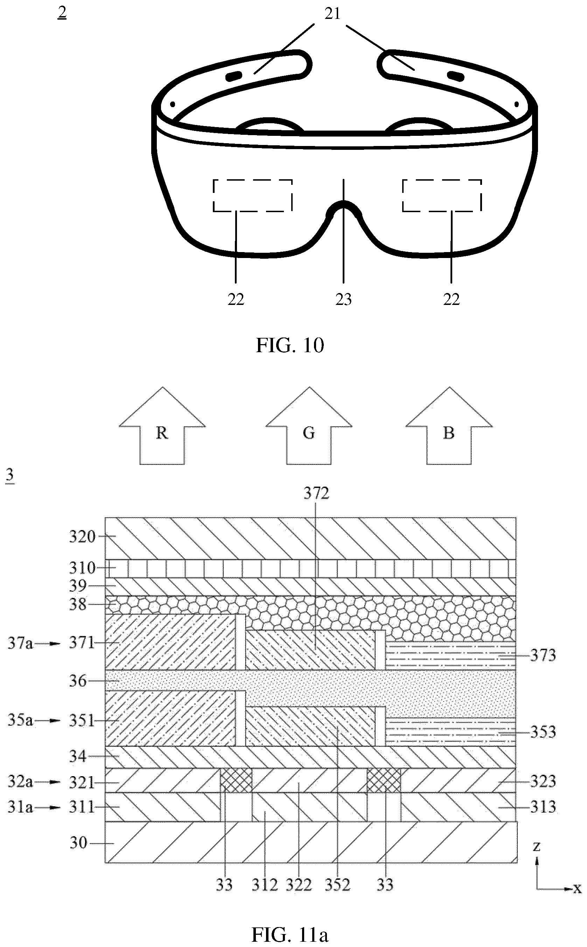

As shown in FIG. 10, the electronic device 2 may be VR glasses or MR glasses, the mechanical part 21 may include a spectacle frame, a head-mounted display apparatus 23 may be mounted on the spectacle frame, and the display 22 may be disposed in the head-mounted display apparatus 23. It may be considered that the display 22 is also mounted on the spectacle frame. The display 22 may include a rigid cover and a display panel that are attached to each other. When the electronic device 2 is MR glasses, a camera and/or another sensor may be further built in the head-mounted display apparatus 23.

The following describes in detail the display panel in embodiments of this application.

FIG. 11a is a diagram of a partial sectional structure of a display panel 3 according to Embodiment 1. The display panel 3 may be a tandem OLED display panel. As shown in FIG. 11a, the display panel 3 may include a substrate 30, a TFT 311, a TFT 312, a TFT 313, an anode 321, an anode 322, an anode 323, a PDL 33, a hole function layer 34, a light emitting layer 35a, an organic connection layer 36, a light emitting layer 37a, an electron function layer 38, a cathode 39, a CPL 310, and an encapsulation layer 320.

It may be understood that FIG. 11a merely shows a position relationship between material layers, and does not limit whether the material layers are directly connected. In addition, the material layers shown in FIG. 11a are not all material layers of the display panel 3. Based on a requirement, the display panel 3 may further include another stack, for example, a touch layer formed on the encapsulation layer 320, and a polarizer formed on the touch layer. In another implementation, the display panel 3 may not include the polarizer, and the display panel 3 may be manufactured by using a colorfilter on encapsulation (colorfilter on encapsulation, COE) technology.

The substrate 30 includes but is not limited to a substrate that can drive the light emitting layer to emit light, for example, a hard glass substrate, a flexible substrate, or a silicon substrate. The flexible substrate includes but is not limited to a substrate that can be bent or folded or whose shape can be arbitrarily changed, for example, polyimide (polyimide, PI) or a fabric. The silicon substrate includes but is not limited to a monocrystalline silicon wafer.

A TFT array layer 31a may be formed on the substrate 30, and the TFT array layer 31a may include a plurality of TFTs arranged in an array, for example, the TFT 311, the TFT 312, and the TFT 313 shown in FIG. 11a. Each TFT is configured to drive one subpixel.

An anode array layer 32a may be formed on the TFT array layer 31a, and the anode array layer 32a includes a plurality of anodes arranged in an array, for example, the anode 321, the anode 322, and the anode 323 shown in FIG. 11a. Each anode may be made of an inorganic or metal material, for example, indium tin oxide (ITO), titanium (Ti), silver (Ag), and aluminum (Al). Each anode may generate holes under an applied drive voltage, and the holes from the anode move toward the light emitting layer under driving of the applied drive voltage.

As shown in FIG. 11a, the PDL 33 may be formed between the anodes to isolate the anodes. No isolation structure like an isolation groove or an isolation pillar is disposed on the PDL 33. The PDL 33 presents a flat structure in a region between any two anodes, and a surface of the region is continuous and has no protrusion or groove.

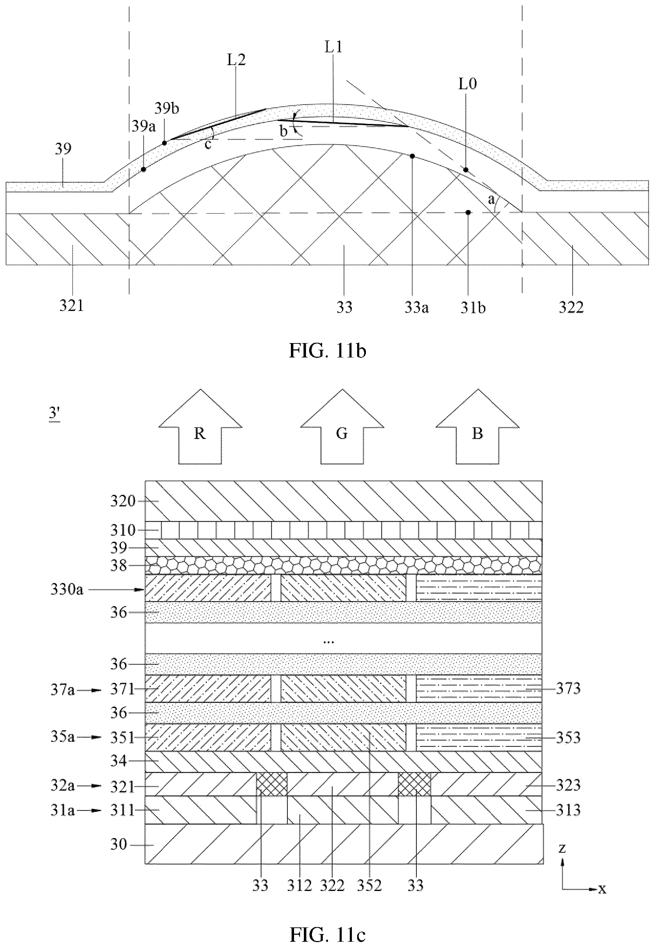

Geometric descriptions of the flat structure may be provided with reference to FIG. 11b. FIG. 11b may represent a schematic microstructure of a stack that is located between the adjacent anode 321 (or referred to as a first anode) and anode 322 (or referred to as a second anode) and that is from the anode to the cathode 39. As shown in FIG. 11b, between the anode 321 and the anode 322, the PDL 33 may be in a water drop shape, and a taper angle a of the PDL 33 may be defined as follows: A tangent line L0 of an arc surface 33a is drawn passing through an intersection point between the arc surface 33a of the PDL 33 and a top surface 31b of the anode, and an acute angle formed between the tangent line L0 and the top surface 31b is referred to as the taper angle a. For a part that is of the cathode 39 and that is located between the adjacent anode 321 and anode 322, an acute angle formed between the top surface 31b and a connection line between any two points on a surface 39a that is of the cathode 39 and that faces the PDL 33 is less than or equal to the taper angle a, for example, an acute angle b formed between a connection line L1 and the top surface 31b is less than the taper angle a; and an acute angle formed between the top surface 31b and a connection line between any two points on a surface 39b that is of the cathode 39 and that faces away from the PDL 33 is less than or equal to the taper angle a, for example, an acute angle c formed between a connection line L2 and the top surface 31b is less than the taper angle a. FIG. 11b shows only a case in which the acute angle formed between the connection line and the top surface 31b is less than the taper angle a. It is easy to understand that there is such a connection line, and an acute angle formed between the connection line and the top surface 31b is equal to the taper angle a.

In this embodiment, because no isolation structure is disposed on the PDL 33, the hole function layer 34, the organic connection layer 36, the electron function layer 38, the cathode 39, and the CPL 310 are all continuous, and there is no partially disconnected film layer. These continuously extending layers, such as the hole function layer 34, the organic connection layer 36, the electron function layer 38, the cathode 39, and the CPL 310, in which all regions are interconnected may be referred to as common layers.

As shown in FIG. 11a, the hole function layer 34 may be located above the anode array layer 32a and the PDL 33. The hole function layer 34 may include a hole injection layer (hole injection layer, HIL), a hole transport layer (hole transport layer, HTL), and an electron blocking layer, and the anode array layer 32a, the hole injection layer, the hole transport layer, and the electron blocking layer may be sequentially stacked. The hole injection layer may enable holes from each anode to be smoothly injected into the hole transport layer. A material of the hole transport layer may be an aromatic amine material, for example, HTC01. The hole transport layer may transmit the holes to the light emitting layer. The electron blocking layer is configured to prevent electrons from entering the hole transport layer. In this embodiment, the hole function layer 34 may be an organic conducting-surface (organic conducting-surface, OCS) structure. In another embodiment, the hole function layer 34 may not include the electron blocking layer based on a requirement.

As shown in FIG. 11a, the hole function layer 34, the light emitting layer 35a, the organic connection layer 36, the light emitting layer 37a, the electron function layer 38, the cathode 39, and the CPL 310 may be sequentially stacked.

The light emitting layer 35a and the light emitting layer 37a are connected in series through the organic connection layer 36, to form a tandem OLED structure of the two light emitting layers. It may be understood that this is merely an example, and a quantity of light emitting layers connected in series is not limited in Embodiment 1. For example, there may alternatively be three or more light emitting layers, and any two light emitting layers are connected in series through one organic connection layer 36.

In Embodiment 1, the light emitting layer may include a plurality of light emitting units arranged in an array according to a specific rule. These light emitting units include but are not limited to a red light emitting unit (R), a green light emitting unit (G), a blue light emitting unit (B), a white light emitting unit (W), and a yellow light emitting unit (Y). For example, the light emitting layer 35a includes a red light emitting unit 351, a green light emitting unit 352, and a blue light emitting unit 353, and the light emitting layer 37a includes a red light emitting unit 371, a green light emitting unit 372, and a blue light emitting unit 373. The red light emitting unit may be formed by mixing a host material and a red light emitting material dopant, the green light emitting unit may be formed by mixing a host material and a green light emitting material dopant, and the blue light emitting unit may be formed by mixing a host material and a blue light emitting material dopant.

A gap may exist between the red light emitting unit (R), the green light emitting unit (G), and the blue light emitting unit (B), or the red light emitting unit (R), the green light emitting unit (G), and the blue light emitting unit (B) may overlap and be connected. It may be understood that the red light emitting unit (R), the green light emitting unit (G), and the blue light emitting unit (B) in FIG. 11a are sequentially arranged along the x axis. This is merely an example. Actually, an arrangement pattern of the subpixels may be set as required, and is not limited in Embodiment 1. For example, a plurality of adjacent light emitting units in a region may emit light of a same color, or may emit light of different colors.

As shown in FIG. 11a, a height of the red light emitting unit may be greater than a height of the green light emitting unit, and the height of the green light emitting unit may be greater than a height of the blue light emitting unit. For example, a height of the red light emitting unit 351 may be greater than a height of the green light emitting unit 352, and the height of the green light emitting unit 352 may be greater than a height of the blue light emitting unit 353. The height is a size of the light emitting unit in a z-axis direction, or is referred to as a thickness. Therefore, the height of the red light emitting unit (R), the height of the green light emitting unit (G), and the height of the blue light emitting unit (B) decrease sequentially, microcavity structures may be constructed for the red light emitting unit (R), the green light emitting unit (G), and the blue light emitting unit (B) respectively, and the microcavity structure can generate a microcavity effect, to improve a light output ratio of the OLED, and improve light emitting efficiency and luminance of the OLED.

In another embodiment, different from Embodiment 1, a height relationship between the red light emitting unit (R), the green light emitting unit (G), and the blue light emitting unit (B) may not be limited. For example, in a display panel 3' shown in FIG. 11c, heights of light emitting units in each light emitting layer may be consistent or basically consistent, for example, heights of the red light emitting unit 351, the green light emitting unit 352, and the blue light emitting unit 353 in the light emitting layer 35a may be consistent or basically consistent. In addition, there may also be three or more light emitting layers in the display panel 3'. For example, FIG. 11c shows light emitting layers such as the light emitting layer 35a, the light emitting layer 37a, and a light emitting layer 330a. Any two light emitting layers are connected in series through one organic connection layer 36.

In Embodiment 1, the light emitting layer may further include a preset layer (primer), and the light emitting unit is formed on the preset layer. For example, the red light emitting unit 351, the green light emitting unit 352, and the blue light emitting unit 353 in the light emitting layer 35a are all formed on the preset layer. The preset layer is configured to adjust microcavities of different light colors.

In Embodiment 1, the organic connection layer 36 has functions of generating a charge, transporting the charge, and injecting the charge into the light emitting layer. The charge includes an electron and a hole. This also applies to the following. The organic connection layer 36 has an extremely small nanometer-scale thickness, and the thickness may be less than or equal to 300 nm, for example, 2 nm, 10 nm, 50 nm, 100 nm, or 300 nm. The organic connection layer 36 is essentially an organic nano-film, and may include at least one of an organic conducting-surface (organic conducting-surface, OCS) and an organic-inorganic hybrid conducting-surface (organic-inorganic hybrid conducting-surface, OIHCS). Based on a conduction characteristic, the organic conducting-surface is classified into an N-type conducting-surface, a P-type conducting-surface, and a bipolar conducting-surface. An electron mobility of the N-type conducting-surface is far greater than that of the P-type conducting-surface, and only electrons are conducted in terms of appearance, for example, a hole blocking layer, an electron transport layer, an N-CGL, and an interlayer that are described below. A hole mobility of the P-type conducting-surface is far greater than the electron mobility, and only holes are conducted in terms of appearance, for example, a P-CGL, a hole injection layer, and a hole transport layer that are described below. An electron mobility and a hole mobility of the bipolar conducting-surface are equivalent, and both electrons and holes can be conducted in terms of appearance, for example, an interlayer. An evaluation indicator of the organic conducting-surface may include a conducting-surface square resistance and a longitudinal mobility. For the N-CGL and the P-CGL, an evaluation indicator of a charge generation capability may be additionally added.

Material modification may be performed on the organic conducting-surface and the organic-inorganic hybrid conducting-surface through doping, to adjust a horizontal square resistance, a longitudinal mobility, and a charge generation capability. Horizontal crosstalk can be reduced by adjusting the foregoing characteristics. A specific principle is further described below.

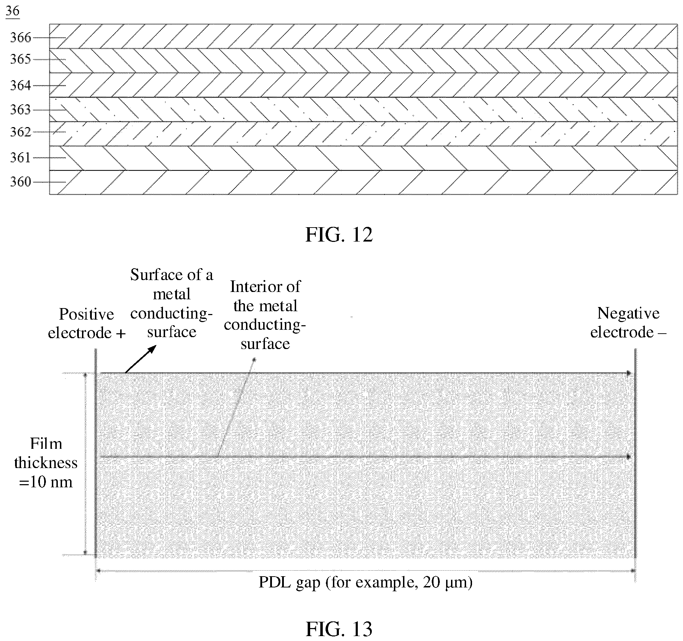

In Embodiment 1, as shown in FIG. 12, for example, the organic connection layer 36 may include a hole blocking layer 360, an electron transport layer 361, an N-type CGL 362, a P-type CGL 363, a hole injection layer 364, a hole transport layer 365, and an electron blocking layer 366 that are sequentially stacked. With reference to FIG. 12 and FIG. 11a, the hole blocking layer 360 may be close to the light emitting layer 35a, and the electron blocking layer 366 may be close to the light emitting layer 37a.

A function of the hole blocking layer 360 is to prevent holes in the light emitting layer 35a from entering the electron transport layer 361, to avoid carrier quenching. A function of the electron transport layer 361 is to transport electrons to the red light emitting unit 351, the green light emitting unit 352, and the blue light emitting unit 353 that are close to the anode.

Under an applied drive voltage, holes and electrons are generated at an interface between the N-type CGL 362 and the P-type CGL 363. A function of the N-type CGL 362 is to transport the electrons at the interface between the N-type CGL 362 and the P-type CGL 363 to the adjacent electron transport layer 361. A function of the P-type CGL 363 is to transport the holes at the interface between the N-type CGL 362 and the P-type CGL 363 to the adjacent hole injection layer 364 or the hole transport layer 365.

In Embodiment 1, the N-type CGL 362 and the P-type CGL 363 form a two-layer CGL. In another embodiment, there may be an interlayer (interlayer) between the N-type CGL 362 and the P-type CGL 363, the interlayer connects the N-type CGL 362 and the P-type CGL 363, and the interlayer may implement a bridging function, to reduce a barrier between the N-type CGL 362 and the P-type CGL 363. The interlayer may be a single-layer structure, or may be a multi-layer structure, for example, a structure with two or more layers. When the interlayer is a single-layer structure, the N-type CGL 362, the interlayer, and the P-type CGL 363 may form a three-layer CGL. When the interlayer is a multi-layer structure, the N-type CGL 362, the interlayer, and the P-type CGL 363 may form a multi-layer CGL.

The hole injection layer 364 is configured to transport the holes transported from the P-type CGL 363 to the hole transport layer 365.

The hole transport layer 365 is configured to transport the holes transported from the P-type CGL 363 or the hole injection layer 364 to the light emitting unit.

The electron blocking layer 366 is configured to prevent electrons in the light emitting layer 37a from entering the hole transport layer 365.

Different from Embodiment 1, in another embodiment, the organic connection layer may not include any one or more of the hole blocking layer 360, the electron transport layer 361, the hole injection layer 364, the hole transport layer 365, and the electron blocking layer 366. For example, the organic connection layer may include the electron transport layer 361, the N-type CGL 362, the P-type CGL 363, and the hole transport layer 365, and not include the hole blocking layer 360 and the hole injection layer 364. Alternatively, the organic connection layer may include the N-type CGL 362 and the P-type CGL 363, and not include the hole blocking layer 360, the electron transport layer 361, the hole injection layer 364, and the hole transport layer 365.

In Embodiment 1, a material of the organic connection layer 36 includes a host material and a doped material doped in the host material. Doping modification is performed, so that the organic connection layer 36 can have an ultra-high horizontal square resistance. For example, a square resistance in any horizontal direction may be greater than or equal to 1 GΩ/□, for example, 1 GΩ/□, 10 GΩ/□, 50 GΩ/□, 196 GΩ/□, or the like. The organic connection layer 36 with a high horizontal square resistance can greatly reduce horizontal crosstalk.

In an implementation, doping modification is performed on the N-type CGL 362. A material of the N-type CGL 362 includes an N-type host material and an N-type doped material.

The N-type host material may be an organic aromatic material, for example, an organic material containing groups such as pyridine, pyazine, pyrimidine, triazine, imidazole, phenyl, naphthyl, anthranyl, phenanthryl, and pyrenyl. Alternatively, the N-type host material may be an organic material containing the foregoing types of groups and isotope substitutions such as deuterium, tritium, and N¹⁵, for example, an organic material like TmPyPB (1,3,5-tris(3-pyridyl-3-phenyl) benzene), Bphen (4,7-diphenyl-1,10-phenanthroline), and TPBi (1,3,5-tris(1-phenyl-1H-benzimidazol-2-yl)benzene).

The N-type doped material may include a metal material whose work function is less than or equal to 3.5 eV, for example, ytterbium (Yb), lithium (Li), samarium (Sm), barium (Ba), cesium (Cs), or calcium (Ca), or may include a metal oxide material whose work function is less than or equal to 3.5 eV, for example, lithium oxide (Li₂O), lithium carbonate (Li₂CO₃), cesium oxide (Cs₂O), or cesium carbonate (Cs₂CO₃), or may include an organic material whose work function is less than or equal to 3.5 eV, for example, Liq (8-hydroxyquinolinolato-lithium) and Libpp (lithium 2-(2',2"-bipyridine -6'-yl)-phenolate), or an organic-metal coordination compound material whose work function is less than or equal to 3.5 eV. A doping concentration of the N-type doped material may be less than or equal to 100%, for example, may be 0% to 3%, for example, may be 0.5%.

In Embodiment 1, material types of the N-type host material and the N-type doped material are independent of each other. Based on a requirement, any N-type doped material may be doped into any N-type host material.

In Embodiment 1, when the N-type doped material is an organic material, the N-type CGL 362 formed through doping may be referred to as an organic conducting-surface. When the N-type doped material is an inorganic material, the N-type CGL 362 formed through doping may be referred to as an organic-inorganic hybrid conducting-surface.

In an implementation, doping modification is performed on the P-type CGL 363. A material of the P-type CGL 363 includes a P-type host material and a P-type doped material.

The P-type host material includes an organic aromatic material, for example, an organic material containing groups such as a primary amino group, a secondary amino group, a tertiary amino group, quaternary ammonium, phenyl, naphthyl, anthranyl, phenanthryl, pyrenyl, fluorenyl, and spirofluorenyl. Alternatively, the P-type host material may be an organic material containing the foregoing types of groups and isotope substitutions such as deuterium, tritium, and N¹⁵, for example, an organic material like TAPC (4-[1-[4-[bis(4-methylphenyl)amino]phenyl]cyclohexyl]-N-(3-methylphenyl)-N-(4-methylphenyl)benzenamine), NPB (N,N'-diphenyl-N,N'-(1-naphthyl)-1,1'-biphenyl-4,4'-diamine), and TCTA (4,4',4'-tris(carbazol-9-yl)-triphenylamine).

The P-type doped material may include an organic material with a deep LUMO (lowest unoccupied molecular orbit, lowest unoccupied molecular orbital) energy level, for example, an LUMO energy level less than or equal to -3.0 eV. For example, the P-type doped material may be specifically an organic material like NDP-9 (4-({2,3-bis[cyano(4-cyano-2,3,5,6-tetrafluorophenyl)methylidene]cyclopropylidene}(cyano)methyl)-2,3,5,6-tetrafluorobenzene-1-carbonitrile), HAT-CN (2,3,6,7,10,11-hexacyano-1,4,5,8,9,12-hexaazatriphenylene), and F4-TCNQ (2,3,5,6-tetrafluoro-7,7,8,8-tetracyanoquinodimethane). Alternatively, the P-type doped material may include an inorganic material whose work function is greater than or equal to 3.0 eV, for example, indium tin oxide (ITO), molybdenum trioxide (MoO₃), vanadium pentoxide (V₂O₅), ferric chloride (FeCl₃), tungsten trioxide (WO₃), and rhenium trioxide (ReO₃). A doping concentration of the P-type doped material may be less than or equal to 100%, for example, may be 0% to 20%, for example, may be 1%.

In Embodiment 1, material types of the P-type host material and the P-type doped material are independent of each other. Based on a requirement, any P-type doped material may be doped into any P-type host material.

In Embodiment 1, when the P-type doped material is an organic material, the P-type CGL 363 formed through doping may be referred to as an organic conducting-surface. When the P-type doped material is an inorganic material, the P-type CGL 363 formed through doping may be referred to as an organic-inorganic hybrid conducting-surface. In Embodiment 1, doping modification may be performed on the N-type CGL 362 or the P-type CGL 363, or doping modification may be performed on both the N-type CGL 362 and the P-type CGL 363.

In conclusion, the organic connection layer 36 may include at least one of the organic conducting-surface and the organic-inorganic hybrid conducting-surface. The following describes a principle of enabling the organic connection layer 36 to have a high horizontal square resistance through doping modification.

It has been described above that the organic connection layer 36 may include the organic conducting-surface. The organic conducting-surface is essentially an organic nano-film with an extremely small thickness (for example, the thickness may be less than or equal to 100 nm). Different from an inorganic material like metal or a semiconductor, the organic conducting-surface has a hyper square resistance (hyper square resistance, HSR) characteristic. To be specific, as a film thickness of the organic conducting-surface decreases, the horizontal square resistance of the organic conducting-surface changes. Generally, the horizontal square resistance increases sharply, and a characteristic of the horizontal square resistance changing with the film thickness does not comply with a resistivity formula R=ρ*L/S, where ρ is a resistivity of a material used to make a resistor, L is a length of a conducting wire used to make the resistor by winding, S is a cross-sectional area of the conducting wire used to make the resistor by winding, and R is a resistance value.

A hyper square resistance characteristic of the organic conducting-surface can be intuitively learned from the following Table 1 and Table 2. Table 1 and Table 2 show test currents (the third column in the table) measured at a same test voltage 20 V for different component structures derived from the reference SID 2022 DIGEST, 877-880, real square resistances (the fourth column in the table) calculated based on R=U/I, and square resistances (the fifth column in the table) calculated based on the resistivity formula. From No. 5 to No. 1 in Table 1, film thicknesses of organic conducting-surfaces in the component structures decrease sequentially. From No. 9 to No. 6 in Table 2, film thicknesses of organic conducting-surfaces in the component structures decrease sequentially. Data in the column of an actual square resistance calculation result in each row in Table 1 is represented by a ratio of the actual square resistance calculation result in each row to an actual square resistance calculation result of No. 5 (the actual square resistance calculation result of No. 5 is used as the reference 100%). Same reference processing is also performed on data in the column of a resistivity formula calculation result in Table 1. Data in the column of an actual square resistance calculation result in each row in Table 2 is represented by a ratio of the actual square resistance calculation result in each row to an actual square resistance calculation result of No. 9 (the actual square resistance calculation result of No. 9 is used as the reference 100%). The same reference processing is also performed on data in the column of a resistivity formula calculation result in Table 2.

**Table 1: Square resistance calculation results of organic conducting-surfaces of component structures 1 to 5**

| No. | Component structure | Test current @ 20 V/µA | Actual square resistance calculation result | Resistivity formula calculation result |
|---|---|---|---|---|
| 1 | ITO/HTC01: 3% NDP-9 (10 nm)/ITO | 0.07 | 7442% | 500% |
| 2 | ITO/HTC01: 3% NDP-9 (20 nm)/ITO | 0.5 | 907% | 250% |
| 3 | ITO/HTC01: 3% NDP-9 (30 nm)/ITO | 1.7 | 279% | 167% |
| 4 | ITO/HTC01: 3% NDP-9 (40 nm)/ITO | 3.1 | 153% | 125% |
| 5 | ITO/HTC01: 3% NDP-9 (50 nm)/ITO | 4.8 | 100% (Ref) | 100% (Ref) |

**Table 2: Square resistance calculation results of organic conducting-surfaces of component structures 6 to 9**

| No. | Component structure | Test current @ 20 V/µA | Actual square resistance calculation result | Resistivity formula calculation result |
|---|---|---|---|---|
| 6 | ITO/HTC01: 15% NDP-9 (10 nm)/ITO | 1.0 | 2072% | 700% |
| 7 | ITO/HTC01: 15% NDP-9 (30 nm)/ITO | 7.9 | 267% | 233% |
| 8 | ITO/HTC01: 15% NDP-9 (50 nm)/ITO | 14.1 | 149% | 140% |
| 9 | ITO/HTC01: 15% NDP-9 (70 nm)/ITO | 21.1 | 100% (Ref) | 100% (Ref) |

A mechanism that the organic conducting-surface has a hyper square resistance characteristic may be explained by using hypotheses of carrier transmission along a molecular orbit and a difference in carrier transmission on a surface and an interior of the organic conducting-surface.

For comparison, a transmission characteristic of a carrier in a nano-film made of metal, namely, a metal conducting-surface (metal conducting-surface, MCS), is first described. FIG. 13 is a diagram illustrating a principle of a hyper square resistance characteristic of an organic conducting-surface. A condition in which a pixel definition layer gap (pixel definition layer Gap, PDL gap) is specified (for example, 20 µm) and a film thickness of the organic conducting-surface is equal to 10 nm is used as an example. As shown in FIG. 13, for a surface and an interior of the metal conducting-surface, because a diameter of a metal molecule is less than 0.5 nm (for example, a radius of an Ag atom is 0.144 nm), metal molecules are tightly stacked, and the metal molecules are connected to each other via a strong metal bond, the connection is tight. Transmission behaviors of the carrier in an interior of the thin film and on a surface of the thin film are slightly different, and transmission capabilities are the same, so that the carrier can quickly pass through the metal nano-film in a horizontal direction, the carrier is transmitted along a shortest path, and a transmission path of the carrier is approximately equal to a minimum distance between a positive electrode and a negative electrode. Therefore, when the carrier is horizontally transmitted on the metal conducting-surface, the resistivity formula R=ρ*L/S is followed, and there is no hyper square resistance phenomenon.

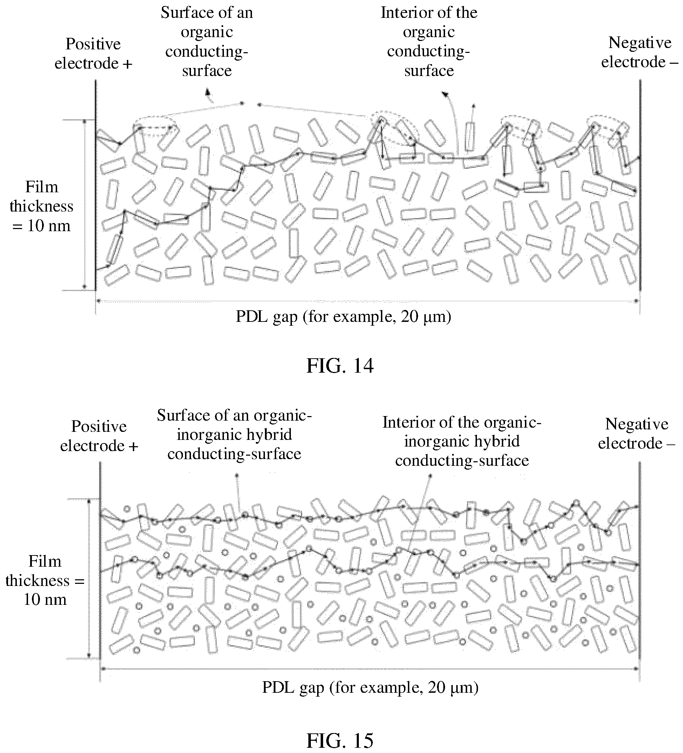

As shown in FIG. 14, for the organic conducting-surface, because organic molecules are in an irregular shape, and a diameter of the molecule is large (reaching a nanometer scale the same as that of the organic conducting-surface), an action force between the molecules is weaker than that of a covalent bond, a metal bond, and an ion bond. Because there are a large quantity of structures of benzene rings and conjugated double bonds in an organic material that forms the OLED, there is a large amount of π-π stacking between the molecules, and it is easy to transmit the carrier between different molecules via these π bonds with a delocalization feature. Because the molecules are stacked in disorder when the organic material is formed into a film, π-π stacking between the molecules is also arranged in disorder. As a result, a transmission channel is also in disorder. Based on such disorder, and a case in which the transmission channel for the carrier on a surface of the organic conducting-surface has a two-dimensional feature, and the carrier inside the organic conducting-surface has a three-dimensional feature, it can be learned that, for the surface of the organic conducting-surface, interaction between the molecules like π-π stacking is weak, a quantity of transmission channels is small, and transmission performance is poor. For an interior of the organic conducting-surface, interaction between the molecules like π-π stacking is strong, a quantity of transmission channels is large, and transmission performance is better than that of the surface of the organic conducting-surface. A surface closer to the organic conducting-surface has a poorer transmission characteristic, and the surface of the organic conducting-surface has a worst transmission characteristic. Therefore, a thinner organic conducting-surface indicates a higher proportion of carrier transmission on the film surface and a higher increased impedance, leading to the hyper square resistance phenomenon. According to this hypothesis, for the highest occupied molecular orbital (highest occupied molecular orbital, HOMO) and the lowest unoccupied molecular orbital (lowest unoccupied molecular orbital, LUMO), a larger orbital size indicates weaker interaction between the molecules like π-π stacking and a thinner organic conducting-surface, and more likely leads to the super square resistance characteristic.

For comparison, as shown in FIG. 15, in the organic-inorganic hybrid conducting-surface, for example, an organic-inorganic hybrid conducting-surface with a thickness of 10 nm that is prepared by doping 5% by weight of metal Yb or Li into an organic molecule with a molecular weight of about 800 Da, for a surface of the organic-inorganic hybrid conducting-surface, because an inorganic material like metal with a small molecular weight is filled in a gap between organic molecules, a quantity of carrier transmission channels is increased, a transmission capability of the surface is greatly enhanced, and a difference between the transmission capability of the surface and a transmission capability of an interior of the organic-inorganic hybrid conducting-surface is reduced; and for the interior of the organic-inorganic hybrid conducting-surface, because an inorganic material like metal with a small molecular weight is filled in a gap between organic molecules, an internal transmission path is shortened, and the transmission capability of the interior is enhanced. Therefore, when a doping concentration of the inorganic material with a small molecular weight and good transmission performance decreases, a square resistance of the organic-inorganic hybrid conducting-surface increases greatly, and the hyper square resistance phenomenon is more significant. The organic conducting-surface can also be explained according to the same mechanism.

In Embodiment 1, doping modification is performed, so that a longitudinal mobility of the N-type CGL 362 may be close to that of the P-type CGL 363. For example, a difference between the longitudinal mobilities may be less than 10 times. Therefore, the organic connection layer 36 may have a high longitudinal mobility. This helps reduce a drive voltage and reduce power consumption. For example, the drive voltage may be reduced by 0.2 V to 0.5 V. For example, the longitudinal mobility of the organic connection layer 36 may reach 10⁻⁶ cm²/(V·S) to 10⁻¹ cm²/(V·S), for example, 10⁻⁶ cm²/(V·S), 10⁻³ cm²/(V·S), or 10⁻¹ cm²/(V·S).

In Embodiment 1, doping modification is performed, so that the CGL in the organic connection layer 36 can further have a good charge generation capability. For example, in an electric field of 8V, a current density of a device at a single-charge generation layer may reach more than 100 mA/cm². Improving a charge generation capability is conducive to improving current efficiency (for example, the current efficiency may be improved by 3% to 5%), reducing a drive voltage (for example, the drive voltage may be reduced by 0.2 V to 0.5 V), and prolonging a service life (for example, the service life is prolonged by 20%).

In Embodiment 1, the electron function layer 38 may include a hole blocking layer, an electron transport layer (electron transport layer, ETL), and an electron injection layer (electron injection layer, EIL). The hole blocking layer, the electron transport layer, the electron injection layer, and the cathode 39 may be sequentially stacked. The hole blocking layer is configured to prevent holes from entering the electron transport layer from the light emitting layer. The electron injection layer may enable electrons from the cathode 39 to be smoothly injected into the electron transport layer, and the electron transport layer may transmit the electrons to the light emitting layer. In this embodiment, the electron function layer 38 may be an organic conducting-surface structure. In another embodiment, the electron function layer 38 may not include the hole blocking layer and/or the electron injection layer based on a requirement.

In Embodiment 1, a material of the electron transport layer may be an organic aromatic material, for example, an organic material containing groups such as pyridine, pyazine, pyrimidine, triazine, imidazole, phenyl, naphthyl, anthranyl, phenanthryl, and pyrenyl. Alternatively, the material of the electron transport layer may be an organic material containing the foregoing types of groups and isotope substitutions such as deuterium, tritium, and N¹⁵, for example, an organic material like TmPyPB (1,3,5-tris(3-pyridyl-3-phenyl) benzene), Bphen (4,7-diphenyl-1,10-phenanthroline), and TPBi (1,3,5-tris(1-phenyl-1H-benzimidazol-2-yl)benzene). A material of the electron injection layer may be lithium fluoride (LiF), ytterbium (Yb), or the like.

The cathode 39 may include an electron injection layer and a metal cathode. The electron injection layer, the metal cathode, and the CPL 310 are sequentially stacked. Alternatively, the cathode 39 may include an electron injection layer and an alloy cathode. The electron injection layer, the alloy cathode, and the CPL 310 are sequentially stacked. For example, the material of the electron injection layer may be ytterbium (Yb), lithium (Li), lithium fluoride (LiF), 8-hydroxyquinolinolato-lithium (LiQ), calcium (Ca), cesium (Cs), lithium oxide (Li₂O), or the like. For example, a material of the metal cathode may be silver (Ag), magnesium (Mg), aluminum (Al), gold (Au), or the like, and a material of the alloy cathode may be an alloy of silver (Ag), magnesium (Mg), aluminum (Al), gold (Au), or the like.

As shown in FIG. 11a, in Embodiment 1, the cathode 39 may generate electrons under an applied drive voltage, and the electrons from the cathode 39 move toward the light emitting layer under driving of the applied drive voltage. In some implementations, the cathode 39 may have the function of the electron injection layer in the electron function layer 38. In this case, the electron function layer 38 may not include the electron injection layer.

The CPL 310 is formed on the cathode 39. The CPL 310 may be made of a material having a light refraction effect and a light extraction effect, for example, lithium fluoride (LiF). The CPL 310 may be configured to increase a light output ratio, and may be further configured to adjust light output efficiency and select a spectrum. In some embodiments, there may be no CPL 310.

The encapsulation layer 320 may be formed on the CPL 310, and the encapsulation layer 320 may encapsulate the CPL 310, the cathode 39, the electron function layer 38, the light emitting layer 37a, the organic connection layer 36, the light emitting layer 35a, the hole function layer 34, the PDL 33, the anode array layer 32a, and the TFT array layer 31a. The encapsulation layer 320 may use flexible encapsulation, for example, any one or a combination of a plurality of encapsulation forms such as chemical vapor deposition (chemical vapor deposition, CVD), thin film encapsulation (thin film encapsulation, TFE), and atomic layer deposition (atomic layer deposition, ALD). Alternatively, the encapsulation layer 320 may use rigid encapsulation, for example, glass cement (Frit) + glass cover encapsulation.

The following uses the red light emitting unit 351 and the red light emitting unit 371 as an example to describe a light emitting principle of a subpixel in the display panel 3. A light emitting principle of another light emitting unit is the same as the light emitting principle of the subpixel.

As shown in FIG. 11a, when a drive voltage is applied between the cathode 39 and the anode 321, the electrons from the cathode 39 are injected into the electron function layer 38 and transmitted in the electron function layer 38, and holes from the anode 321 are injected into the hole function layer 34 and transmitted in the hole function layer 34. Under action of the drive voltage, in the CGL of the organic connection layer 36, the carrier transitions between different molecular orbitals under action of an electric field, to generate electrons on a new molecular orbital and transmit the electrons to the adjacent electron transport layer 361, and generate holes on an old molecular orbital and transmit the holes to the adjacent hole injection layer 364 or the hole transport layer 365. The holes from the anode 321 and the electrons from the electron transport layer 361 meet in the red light emitting unit 351 and are recombined into excitons, and the excitons radiate and transition back to a ground state, and emit red light. The electrons from the cathode 39 and the holes from the hole injection layer 364 or the hole transport layer 365 meet in the red light emitting unit 371 and are recombined into excitons, and the excitons radiate and transition back to a ground state, and emit red light. Therefore, the red light emitting unit 351 and the red light emitting unit 371 can emit red light. The red light may be emitted upward from a side of the CPL 310 (which is a top-emitting architecture), or may be emitted downward from a side of the substrate 30 (which is a bottom-emitting architecture).

The following describes a principle in which horizontal crosstalk can be reduced based on a high horizontal resistance characteristic of the organic connection layer 36.

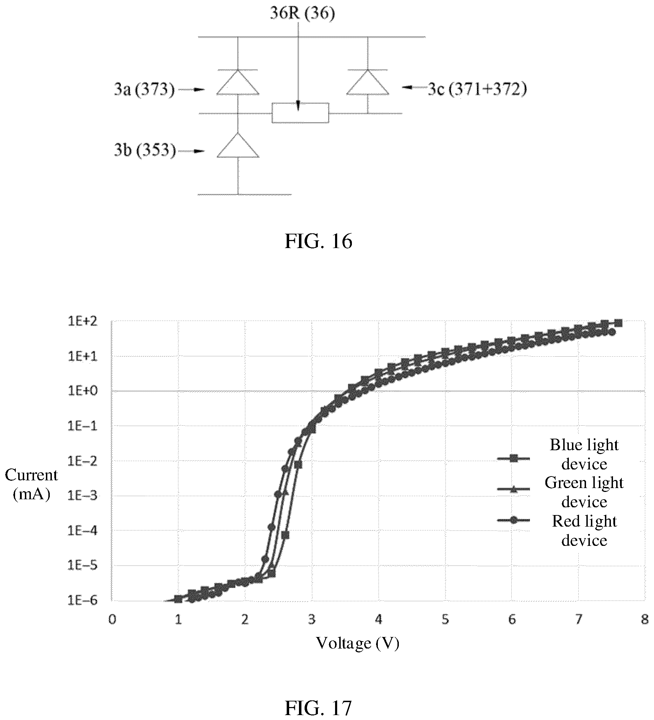

FIG. 16 shows a simple connection circuit of the subpixel in the display panel 3. The circuit may be used as a model for analyzing horizontal crosstalk of a tandem OLED. As shown in FIG. 16, a light emitting unit 3a and a light emitting unit 3b in one subpixel are connected in series to form the tandem OLED. The organic connection layer 36 corresponds to an equivalent resistor 36R, an equivalent resistor 36R, and an equivalent resistor 36R. Therefore, the equivalent resistor 36R is large. Under a rated drive voltage, the light emitting unit 3a and the light emitting unit 3b can be lit up. However, due to voltage division of the equivalent resistor 36R, a voltage at two ends of a light emitting unit 3c is lower than a drive voltage of the light emitting unit 3c, and consequently, it is difficult to light up the light emitting unit 3c. A larger equivalent resistor 36R indicates a lower voltage at two ends of the light emitting unit 3c, and consequently, it is more difficult to light up the light emitting unit 3c. Therefore, a risk of horizontal crosstalk between the light emitting unit 3c and each of the light emitting unit 3a and the light emitting unit 3b is reduced. Therefore, a general conclusion may be derived from FIG. 16: The organic connection layer 36 set with a high horizontal square resistance can reduce horizontal crosstalk, and a larger horizontal square resistance indicates a lower probability of crosstalk.

The following uses specific examples to verify the preceding conclusion.

An OLED device recorded in reference ACS Photonics 2019, 6, 767-778 is used as an example. A structure of the tandem OLED device is as follows:
experimental piece-R: ITO/HAT-CN (5 nm)/TAPC (50 nm)/TCTA (5 nm)/TPB-AC: 3% Ir(dmdppr-dmp)2(divm) (20 nm)/BmPyPB (40 nm)/LiF (1 nm)/Al (120 nm);
experimental piece-G: ITO/HAT-CN (5 nm)/TAPC (50 nm)/TCTA (5 nm)/TPB-AC: 5% Ir(ppy)2acac (20 nm)/BmPyPB (40 nm)/LiF (1 nm)/Al (120 nm); and
experimental piece-B: ITO/HAT-CN (5 nm)/TAPC (50 nm)/TCTA (5 nm)/TPB-AC (20 nm)/BmPyPB (40 nm)/LiF (1 nm)/Al (120 nm).

An area of the experimental piece is 0.16 cm², and measured IV data of the OLED device is shown in FIG. 17. When a current density is 0.0001 mA/cm², a size of a red light subpixel is 20 µm×20 µm, a size of a green light subpixel is 20 µm×30 µm, and a size of a blue light subpixel is 20 µm×40 µm, an internal resistance of an OLED subpixel can be calculated based on the data, as shown in Table 3.

**Table 3: Internal resistance estimation result of an OLED subpixel**

| Subpixel | Red light subpixel | Green light subpixel | Blue light subpixel |
|---|---|---|---|
| Internal resistance at J=0.0001 mA/cm² (unit: GΩ) | 3076 | 2835 | 2415 |

The internal resistance is calculated below with reference to Table 3 and FIG. 16. It is assumed that the light emitting unit 3a and the light emitting unit 3b are two light emitting units in the blue light tandem OLED subpixel, for example, the light emitting unit 3a may correspond to the blue light emitting unit 373, and the light emitting unit 3b may correspond to the blue light emitting unit 353; and the light emitting unit 3c is a light emitting unit on a side close to the cathode in the red light tandem OLED subpixel, for example, the light emitting unit 3c may correspond to the red light emitting unit 371 and the green light emitting unit 372. For example, when blue light is lit up, there is red light crosstalk. At low luminance and a low gray scale, an internal resistance of the light emitting unit 3a is 2415 GΩ, and an internal resistance of the light emitting unit 3c is 3076 GΩ. Lighting up and a drive voltage of the blue light OLED are higher than those of the red light OLED. For example, when a voltage at two ends of the light emitting unit 3a reaches 2.50 V, the light emitting unit 3a is lit up (for example, luminance=0.02 nits), and when the voltage at two ends of the light emitting unit 3c reaches 2.35 V, the light emitting unit 3c is lit up (for example, luminance=0.02 nits). A voltage of 2.5 V is applied to two ends of a parallel circuit formed by the light emitting unit 3a and the equivalent resistor 36R + the light emitting unit 3c. When an equivalent resistance value of the equivalent resistor 36R exceeds 196 GΩ, a divided voltage at two ends of the equivalent resistor 36R exceeds 0.15 V. Because a voltage at two ends of the equivalent resistor 36R + the light emitting unit 3c is 2.5 V, a divided voltage obtained at the two ends of the light emitting unit 3c is less than 2.35 V. Therefore, it can be learned that a larger square resistance of the equivalent resistor 36R indicates a lower probability of lighting up the light emitting unit 3c and a lower crosstalk risk.

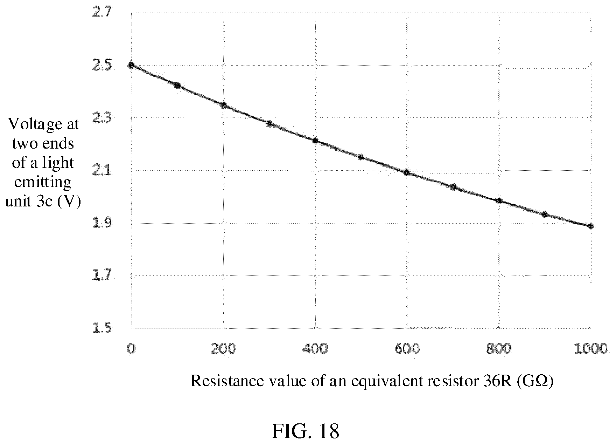

FIG. 18 shows a simulation curve of a relationship between a horizontal square resistance of the organic connection layer 36 and the equivalent resistor 36R, and a lighting voltage at two ends of the light emitting unit 3c. It can be intuitively learned from FIG. 18 that, as the horizontal square resistance of the organic connection layer 36 increases, the drive voltage at the two ends of the light emitting unit 3c decreases to be less than the lighting voltage, and it is more difficult to light up the light emitting unit 3c. Therefore, a horizontal crosstalk risk is reduced.

In Embodiment 1, for example, the RGB subpixels may be directly evaporated by using a fine metal mask (fine metal mask, FMM) method, and the RGB subpixels directly emit light to implement colorization of the display panel 3.

For example, the display panel 3 in Embodiment 1 may be used in a small electronic device like a mobile phone, a tablet computer, a notebook computer, a smartwatch, or a smart band.

In conclusion, in the solution of Embodiment 1, the isolation structure on the PDL is canceled, so that the PDL 33 is a flat structure, so that the cathode 39 can be continuously connected, a voltage drop on the cathode 39 can be reduced, and power consumed by the cathode 39 can be reduced. In this way, a drive voltage and power consumption of the display panel 3 are low, and abnormal pixel lighting can be avoided. In addition, an additionally added photomask and photolithography process can be avoided. This can simplify the process and reduce costs. In addition, reliability of the display panel 3 can be improved. Through doping modification of the organic connection layer 36, horizontal crosstalk can be greatly reduced. Because the organic connection layer 36 does not need to be arranged based on distribution of subpixels, and a pixel design has no impact on a design of the organic connection layer 36, a design for reducing horizontal crosstalk by using the organic connection layer 36 may be applied to all tandem OLED products, so that the design is highly compatible, and can meet a mass production requirement.

Different from Embodiment 1 in which the RGB subpixels directly emit light to implement colorization, in the following embodiment, colorization may be implemented in a manner of white light + a color filter film.

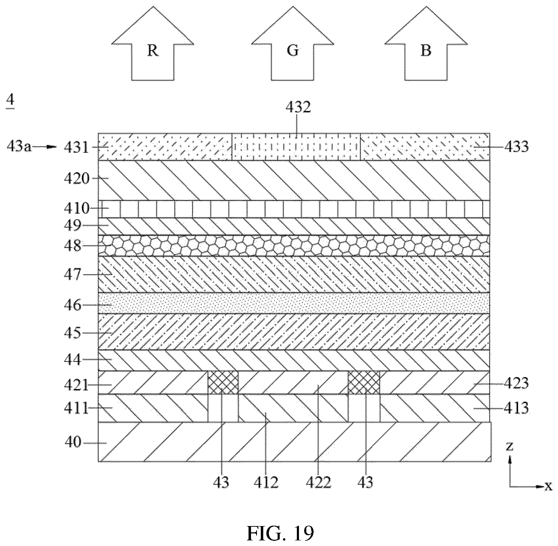

FIG. 19 is a diagram of a partial sectional structure of a display panel 4 according to Embodiment 2. As shown in FIG. 11a, the display panel 4 may include a substrate 40, a TFT 411, a TFT 412, a TFT 413, an anode 421, an anode 422, an anode 423, a PDL 43, a hole function layer 44, a light emitting layer 45, and an organic connection layer 46, a light emitting layer 47, an electron function layer 48, a cathode 49, a CPL 410, an encapsulation layer 420, and a first color filter film (color filter film, CF) 43a.

Same as Embodiment 1, in the display panel 4 in Embodiment 2, an isolation structure on the PDL 43 is canceled, so that the PDL 43 is a flat structure, so that the cathode 49 can be continuously connected, a voltage drop on the cathode 49 can be reduced, and power consumed by the cathode 39 can be reduced. In this way, a drive voltage and power consumption of the display panel 4 are low, and abnormal pixel lighting can be avoided. In addition, an additionally added photomask and photolithography process can be avoided. This can simplify the process and reduce costs. In addition, reliability of the display panel 4 can be improved. Through doping modification of the organic connection layer 46, horizontal crosstalk can be greatly reduced. A design for reducing horizontal crosstalk by using the organic connection layer 46 may be applied to all tandem OLED products, so that the design is highly compatible, and can meet a mass production requirement.

Different from Embodiment 1, the display panel 4 in Embodiment 2 can be colorized in the manner of the white light + the color filter film.

As shown in FIG. 19, both the light emitting layer 45 and the light emitting layer 47 are horizontally continuous organic material layers, and deposition of the light emitting layer 45 or the light emitting layer 47 can be completed through one time of vapor deposition by using only a common metal mask (common metal mask, CMM) process without using an FMM process. The light emitting layer 45 and the light emitting layer 47 may emit light of different colors, and the light of the light emitting layer 45 and the light of the light emitting layer 47 can be mixed into white light. For example, the light emitting layer 45 may include a red light emitting unit (R) and a green light emitting unit (G). Red light emitted by the red light emitting unit (R) and green light emitted by the green light emitting unit (G) may be mixed into yellow light. Therefore, the light emitting layer 45 can emit yellow light. For example, the light emitting layer 47 may include a blue light emitting unit (B), and the light emitting layer 47 can emit blue light. The yellow light emitted by the light emitting layer 45 and the blue light emitted by the light emitting layer 47 may be mixed into white light, and finally all the light emitting layers emit the white light as a whole.

As shown in FIG. 19, the first color filter film 43a may be formed on the encapsulation layer 420. The first color filter film 43a may include a plurality of first red light filter units 431, a plurality of first green light filter units 432, and a plurality of first blue light filter units 433. The first red light filter units 431, the first green light filter units 432, and the first blue light filter units 433 may be arranged in an array according to a specific rule. It may be understood that the first red light filter unit 431, the first green light filter unit 432, and the first blue light filter unit 433 are sequentially arranged along an x-axis. This is merely an example. Actually, an arrangement pattern of the light filter units may be set based on a requirement, and is not limited in Embodiment 2.

Refer to FIG. 19. The white light emitted by the light emitting layers as a whole may be transmitted upward and separately enter the first red light filter unit 431, the first green light filter unit 432, and the first blue light filter unit 433. The first red light filter unit 431 filters the white light and emits red light, the first green light filter unit 432 filters the white light and emits green light, and the first blue light filter unit 433 filters the white light and emits blue light, to implement color display of the display panel 4.

The display panel 4 in Embodiment 2 may use a top-emitting architecture, and light is transmitted upward and emitted from the first color filter film 43a on the encapsulation layer 420. In another embodiment, the display panel 4 may use a bottom-emitting architecture, the first color filter film 43a is located below the substrate 40 (that is, located on a side that is of the substrate 40 and that faces away from the light emitting layer), and light is transmitted downward and emitted from the first color filter film 43a below the substrate 40.

In Embodiment 2, colorization is implemented by using a manner of the white light + the color filter film. This helps improve pixels per inch (pixels per inch, PPI) of the display panel. For example, the display panel 4 in Embodiment 2 is applicable to an electronic device like a silicon-based OLED television or an OLED television.

In another embodiment, based on a requirement, colorization may be implemented in the manner of the white light + the color filter film by using another white light OLED device structure.

For example, in Embodiment 3, refer to FIG. 19. The light emitting layer 45 may include a blue light emitting unit (B), and the light emitting layer 45 can emit blue light. The light emitting layer 47 may include a red light emitting unit (R) and a green light emitting unit (G), and the light emitting layer 45 can emit yellow light. The blue light emitted by the light emitting layer 45 and the yellow light emitted by the light emitting layer 47 may be mixed into white light, and finally all the light emitting layers emit the white light as a whole.

Alternatively, in Embodiment 4, a red light emitting layer, a green light emitting layer, and a blue light emitting layer may be separately disposed, the three light emitting layers are stacked (not limited to being sequentially stacked), and any two light emitting layers are connected in series through one organic connection layer. Red light emitted by the red light emitting layer, green light emitted by the green light emitting layer, and blue light emitted by the blue light emitting layer are mixed into white light, and finally all the light emitting layers emit the white light as a whole.

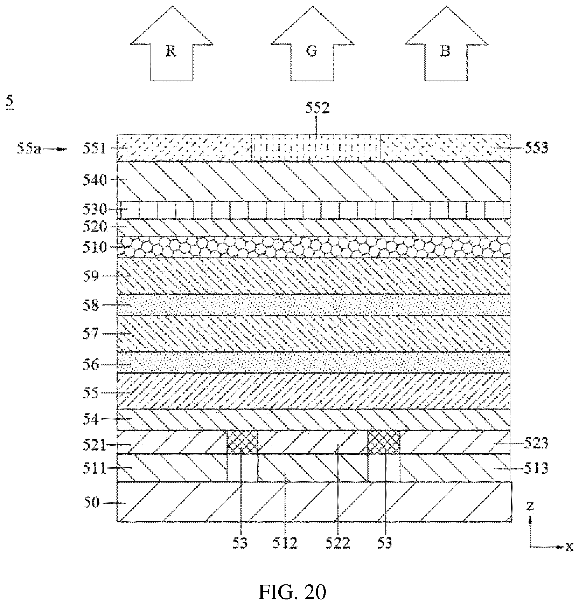

Alternatively, in Embodiment 5 shown in FIG. 20, two light emitting layers emitting blue light and one light emitting layer emitting yellow light may be disposed, and white light is obtained by mixing the blue light and the yellow light. Specifically, as shown in FIG. 20, a display panel 5 in Embodiment 5 may include a substrate 50, a TFT 511, a TFT 512, a TFT 513, an anode 521, an anode 522, an anode 523, a PDL 53, a hole function layer 54, a light emitting layer 55, an organic connection layer 56, a light emitting layer 57, an organic connection layer 58, a light emitting layer 59, an electron function layer 510, a cathode 520, a CPL 530, an encapsulation layer 540, and a first color filter film 55a. The first color filter film 55a may include a plurality of first red light filter units 551, a plurality of first green light filter units 552, and a plurality of first blue light filter units 553.

As shown in FIG. 20, the light emitting layer 55 may include a blue light emitting unit (B), and the light emitting layer 55 may emit blue light. The light emitting layer 57 may include a red light emitting unit (R) and a green light emitting unit (G), and the light emitting layer 57 may emit yellow light. The light emitting layer 59 may include a blue light emitting unit (B), and the light emitting layer 59 may emit blue light. Finally, all the light emitting layers emit white light as a whole. It may be understood that an arrangement sequence of the light emitting layer 55-the light emitting layer 57-the light emitting layer 59 is merely an example. Actually, an arrangement sequence of the light emitting layers may be set based on a requirement, and is not limited in Embodiment 5.

In the tandem OLED, efficiency of emitting blue light by the organic light emitting layer is low, and it is difficult to emit blue light. Therefore, in Embodiment 5, a light emitting layer that emits blue light is additionally disposed, so that light output efficiency of blue light can be improved.

Alternatively, in another embodiment, a first light emitting layer and a second light emitting layer may be separately disposed, and the first light emitting layer and the second light emitting layer are stacked. The first light emitting layer may include a red light emitting unit (R), and the first light emitting layer may emit red light. The second light emitting layer may include a green light emitting unit (G) and a blue light emitting unit (B), and the second light emitting layer may emit cyan light. Finally, all the light emitting layers emit white light as a whole.

Alternatively, in another embodiment, a first light emitting layer and a second light emitting layer may be separately disposed, and the first light emitting layer and the second light emitting layer are stacked. The first light emitting layer may include a green light emitting unit (G), and the first light emitting layer may emit green light. The second light emitting layer may include a red light emitting unit (R) and a blue light emitting unit (B), and the second light emitting layer may emit red light. Finally, all the light emitting layers emit white light as a whole.

It may be understood that only some white light OLED device structures are described above. In embodiments of this application, different white light OLED device structures may be disposed based on a requirement. These white light OLED device structures meet the following design. In a plurality of light emitting layers, at least two light emitting layers may separately emit light of different colors, and light emitted by all the light emitting layers may be mixed into white light. Finally, all the light emitting layers emit the white light as a whole.

Different from the foregoing embodiment in which colorization is implemented in the manner of the white light + the color filter film, in Embodiment 6, colorization may be implemented by using blue light + a color change layer.

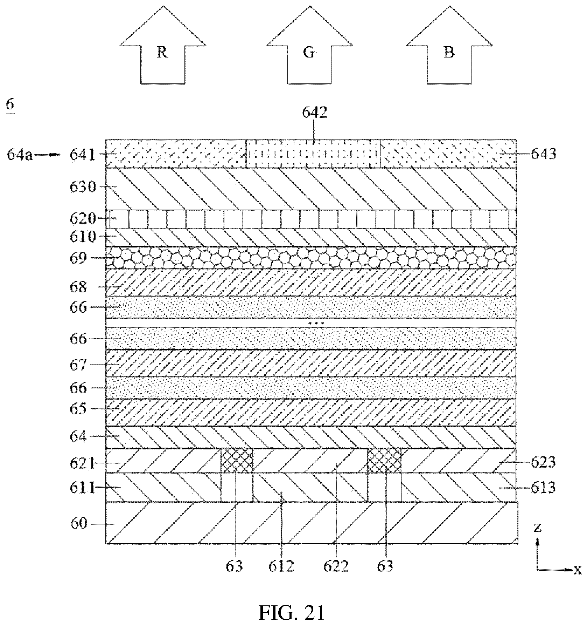

FIG. 21 is a diagram of a partial sectional structure of a display panel 6 according to Embodiment 6. As shown in FIG. 21, the display panel 6 may include a substrate 60, a TFT 611, a TFT 612, a TFT 613, an anode 621, an anode 622, an anode 623, a PDL 63, a hole function layer 64, a light emitting layer 65, an organic connection layer 66, a light emitting layer 67, a light emitting layer 68, an electron function layer 69, a cathode 610, a CPL 620, an encapsulation layer 630, and a color change layer (color change layer, CCL) 64a. The light emitting layer 65, the light emitting layer 67, and the light emitting layer 68 are sequentially stacked, and two adjacent light emitting layers are connected in series through one organic connection layer 66.

Same as Embodiment 2, in the display panel 6 in Embodiment 6, an isolation structure on the PDL 63 is canceled, so that the PDL 63 is a flat structure, so that the cathode 610 can be continuously connected, a voltage drop on the cathode 610 can be reduced, and power consumed by the cathode 610 can be reduced. In this way, a drive voltage and power consumption of the display panel 6 are low, and abnormal pixel lighting can be avoided. In addition, an additionally added photomask and photolithography process can be avoided. This can simplify the process and reduce costs. In addition, reliability of the display panel 6 can be improved. The organic connection layer 66 becomes an organic conducting-surface through doping modification, and horizontal crosstalk can be greatly reduced through doping modification of the organic connection layer 66. A design for reducing horizontal crosstalk by using the organic connection layer 66 may be applied to all tandem OLED products, so that the design is highly compatible, and can meet a mass production requirement.

Different from Embodiment 2, the display panel 6 in Embodiment 6 can be colorized in the manner of blue light + the color change layer.

As shown in FIG. 21, the light emitting layer 65, the light emitting layer 67, and the light emitting layer 68 each include a blue light emitting unit (B), and the light emitting layer 65, the light emitting layer 67, and the light emitting layer 68 each can emit blue light. Finally, all the light emitting layers emit blue light as a whole.

As shown in FIG. 21, the color change layer 64a may be formed on the encapsulation layer 630. The color change layer 64a may include a plurality of red light conversion units 641, a plurality of green light conversion units 642, and a plurality of blue light conversion units 643. The red light conversion units 641, the green light conversion units 642, and the blue light conversion units 643 may be arranged in an array according to a specific rule. It may be understood that the red light conversion unit 641, the green light conversion unit 642, and the blue light conversion unit 643 are sequentially arranged along an x-axis. This is merely an example. Actually, an arrangement pattern of the conversion units may be set based on a requirement, and is not limited in Embodiment 6.

Refer to FIG. 21. The blue light emitted by the light emitting layers as a whole may be transmitted upward and separately enter the red light conversion unit 641, the green light conversion unit 642, and the blue light conversion unit 643. The red light conversion unit 641 may perform color conversion on the blue light and emit red light, the green light conversion unit 642 may perform color conversion on blue light and emit green light, and the blue light conversion unit 643 may narrow a spectrum of the blue light and emit purer blue light, to implement color display of the display panel 6.

The display panel 6 in Embodiment 6 may use a top-emitting architecture, and light is transmitted upward and emitted from the color change layer 64a on the encapsulation layer 630. In another embodiment, the display panel 6 may use a bottom-emitting architecture, the color change layer 64a is located below the substrate 60 (that is, located on a side that is of the substrate 60 and that faces away from the light emitting layer), and light is transmitted downward and emitted from the color change layer 64a below the substrate 60.

In Embodiment 6, for example, to ensure pure light color of the display panel 6, a second color filter film may be further disposed outside the color change layer 64a. The second color filter film may be located on a side that is of the color change layer 64a and that is away from the encapsulation layer 630 (the top-emitting architecture), or located on a side that is of the color change layer 64a and that is away from the substrate 60 (the bottom-emitting architecture). The second color filter film may include a plurality of second red light filter units, a plurality of second green light filter units, and a plurality of second blue light filter units. The second red light filter unit corresponds to the red light conversion unit. The second red light filter unit may filter the red light emitted by the red light conversion unit and emit red light, the second green light filter unit may filter the green light emitted by the green light conversion unit and emit green light, and the second blue light filter unit may filter the blue light emitted by the blue light conversion unit and emit blue light.

In Embodiment 6, colorization is implemented in the manner of blue light + the color change layer. This helps simplify a process, reduce a voltage drop, reduce power consumption of the display panel, and improve luminance of the display panel. For example, the display panel 6 in Embodiment 6 is applicable to an electronic device like a high-luminance television.

Different from Embodiment 6, in another embodiment, the color change layer may not include the blue light conversion unit, the second color filter film may include the second blue light filter unit, and the second blue light filter unit filters the blue light emitted by the light emitting layers.

The foregoing embodiments describe in detail the tandem OLED display panel that uses a PDL with a flat structure and a doping-modified organic connection layer. The following embodiments describe a tandem OLED display panel that uses a PDL with a semi-flat structure + a semi-partitioned structure and a doping-modified organic connection layer.

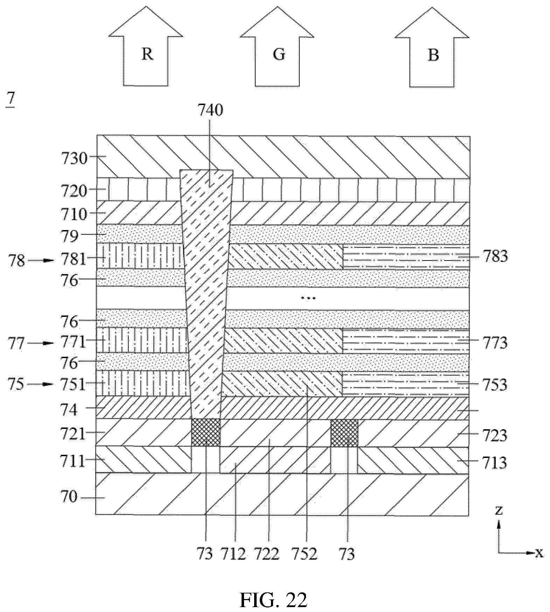

FIG. 22 is a diagram of a partial sectional structure of a display panel 7 in an implementation according to Embodiment 7. As shown in FIG. 22, the display panel 7 may include a substrate 70, a TFT 711, a TFT 712, a TFT 713, an anode 721, an anode 722, an anode 723, a PDL 73, and a hole function layer 74, a plurality of light emitting layers such as a light emitting layer 75, a light emitting layer 77, and a light emitting layer 78, a plurality of organic connection layers 76, an electron function layer 79, a cathode 710, a CPL 720, an encapsulation layer 730, and an isolation structure 740.

Any two adjacent light emitting layers in the display panel 7 may be connected in series through one organic connection layer 76. Each light emitting layer may include a plurality of light emitting units. For example, the light emitting layer 75 may include a light emitting unit 751, a light emitting unit 752, and a light emitting unit 753, the light emitting layer 77 may include a light emitting unit 771, a light emitting unit 772, and a light emitting unit 773, and the light emitting layer 78 may include a light emitting unit 781, a light emitting unit 782, and a light emitting unit 783. Each light emitting layer may further include a preset layer. The light emitting unit is formed on the preset layer, and the preset layer is configured to adjust microcavities of different light colors. For example, each light emitting layer may include a plurality of red light emitting units, green light emitting units, and blue light emitting units. For example, the light emitting unit 771 may be a red light emitting unit, the light emitting unit 772 may be a green light emitting unit, and the light emitting unit 773 may be a blue light emitting unit.

In this embodiment, RGB subpixels may be directly deposited by using an FMM method, and the RGB subpixels directly emit light to implement colorization of the display panel 7.

In this embodiment, except the isolation structure 740, structures, materials, characteristics, operating principles, and the like of other stacks may be the same as those in the foregoing embodiments. Details are not described herein again. The following mainly describes the isolation structure 740.

FIG. 22 shows the isolation structure 740 formed on the PDL 73. The isolation structure 740 may be approximately a pillar structure similar to a pillar, and a specific structure of the isolation structure 740 may be designed based on a requirement. This is not limited in this embodiment. The isolation structure 740 has a large height, and may sequentially penetrate the hole function layer 74, the plurality of light emitting layers, the plurality of organic connection layers 76, the electron function layer 79, the cathode 710, and the CPL 720 in a z-axis direction (namely, a longitudinal direction). The isolation structure 740 enables the hole function layer 74, the organic connection layer 76, the cathode 710, and the CPL 720 to be no longer a continuous and complete entire-plane structure, but to be partially disconnected. The isolation structure 740 further separates adjacent light emitting units (for example, the light emitting unit 751 and the light emitting unit 752 in the light emitting layer 75, the light emitting unit 781 and the light emitting unit 782 in the light emitting layer 78, and the like) in each light emitting layer in some horizontal directions, it may be considered that the isolation structure 740 enables each light emitting layer to be partially disconnected.

Refer to FIG. 22. Due to a process, a cathode material may alternatively be deposited on the top of the isolation structure 740. The cathode material is the same as a material of the cathode 710, but the cathode material does not have a function of the cathode 720. It may be considered that the cathode material is a redundant structure generated in the process. Therefore, the cathode material is not shown in FIG. 22.

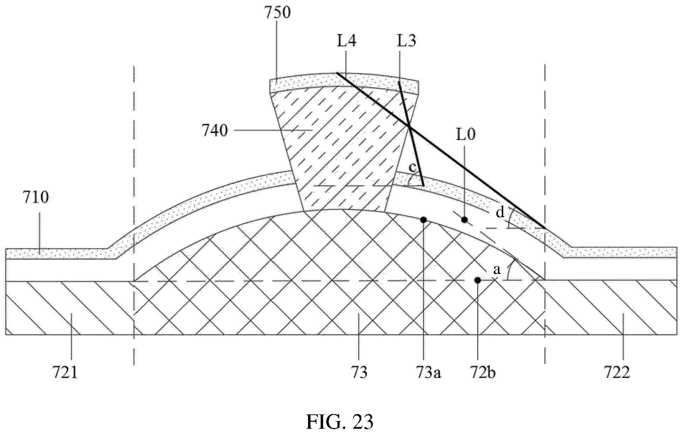

FIG. 23 may represent a schematic microstructure of a stack that is located between the adjacent anode 721 (or referred to as a first anode) and anode 722 (or referred to as a second anode) and that is from the anode to the cathode 710 in FIG. 22. As shown in FIG. 23, between the anode 721 and the anode 722, the PDL 73 may be in a water drop shape, and a taper angle a of the PDL 73 may be defined as follows: A tangent line L0 of an arc surface 73a is drawn passing through an intersection point betwen the arc surface 73a of the PDL 73 and a top surface 72b of the anode, and an acute angle formed between the tangent line L0 and the top surface 72b is referred to as the taper angle a. With reference to FIG. 23 and FIG. 22, in a process of the display panel 7, after the isolation structure 740 is formed on the PDL 73, stacks from the hole function layer 74 to the cathode 710 are formed sequentially (to highlight the focus, only the cathode 710 in these stacks is shown in FIG. 23). Due to a process, the top of the isolation structure 740 may alternatively be covered with a cathode material 750. Therefore, when the isolation structure 740 is prepared, a protrusion structure shown in FIG. 23 is formed. Geometric descriptions of the protrusion structure may be provided as follows: There is a connection line between a point on the cathode material 750 and a point on the cathode 710, and an acute angle formed between the connection line and the top surface 72b is greater than or equal to the taper angle a. For example, there is a connection line L3, and an acute angle d formed between the connection line L3 and the top surface 72b is greater than the taper angle a. Alternatively, there is a connection line L4 parallel to the tangent line L0, and an acute angle e formed between the connection line L4 and the top surface 72b is equal to the taper angle a.

In this implementation, the isolation structure 740 may partially disconnect the organic connection layer 76 in a physical partition manner, to separate subpixels of different colors in the display panel 7, thereby inplementing a function of reducing horizontal crosstalk. Disposing both the isolation structure 740 and the organic connection layer 76 with a high horizontal square resistance can enhance this function, to avoid horizontal crosstalk.

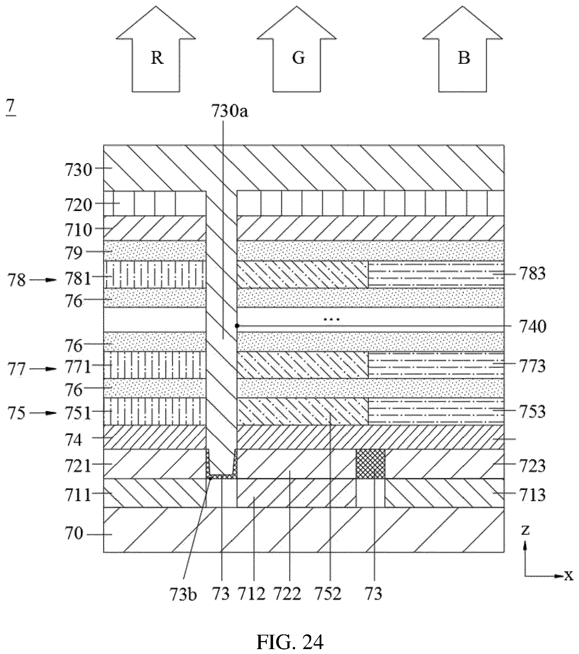

FIG. 24 is a diagram of a partial sectional structure of the display panel 7 in another implementation according to Embodiment 7. Different from that shown in FIG. 22, the isolation structure 740 shown in FIG. 24 may be a groove, and the groove sequentially penetrates upward the hole function layer 74, the plurality of light emitting layers, the plurality of organic connection layers 76, the electron function layer 79, the cathode 710, and the CPL 720, and penetrates downward to a specific depth of the PDL 73. A side that is of the PDL 73 and that faces the substrate 70 is used as a bottom wall 73b of the groove. In a process of the display panel 7, after the groove is formed on the PDL 73, the stacks from the hole function layer 74 to the cathode 710 are sequentially formed. Due to a process, the bottom wall 73b of the groove may alternatively cover a cathode material. The cathode material does not have a function of the cathode 720, but the cathode material cannot be deposited on a side wall of the groove. A part 730a of the encapsulation layer 730 may be filled in the groove and cover the cathode material and the PDL 73. Similarly, the isolation structure 740 enables the hole function layer 74, the organic connection layer 76, the cathode 710, and the CPL 720 to be no longer a continuous and complete entire-plane structure, but to be partially disconnected. The isolation structure 740 further separates adjacent light emitting units (for example, the light emitting unit 751 and the light emitting unit 752 in the light emitting layer 75, the light emitting unit 781 and the light emitting unit 782 in the light emitting layer 78, and the like) in each light emitting layer in some horizontal directions, it may be considered that the isolation structure 740 enables each light emitting layer to be partially disconnected.

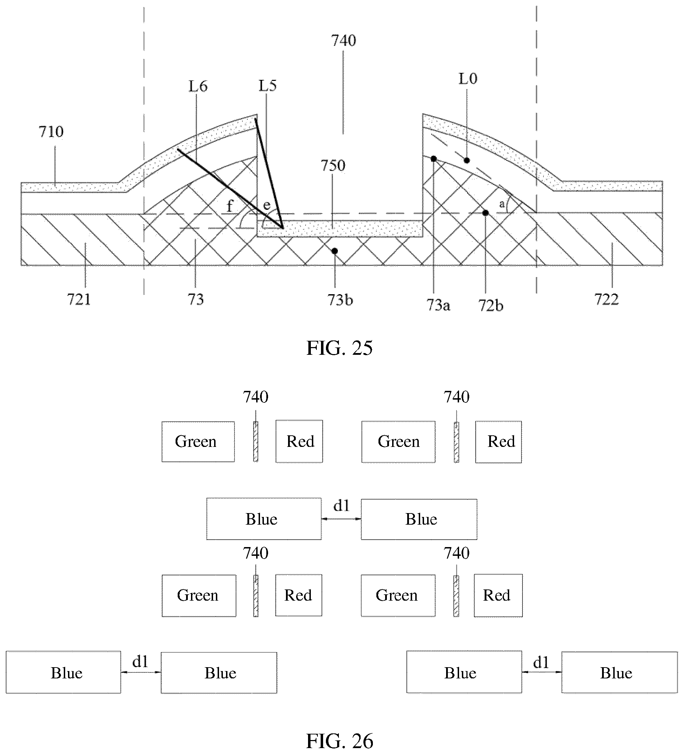

FIG. 25 may represent a schematic microstructure of a stack that is located between the adjacent anode 721 and anode 722 and that is from the anode to the cathode 710 in FIG. 24 (to highlight the focus, only the cathode 710 in these stacks is shown in FIG. 23). As shown in FIG. 25, between the anode 721 and the anode 722, the PDL 73 may be in a water drop shape, and a taper angle a of the PDL 73 may be defined as follows: A tangent line L0 of an arc surface 73a is drawn passing through an intersection point betwen the arc surface 73a of the PDL 73 and a top surface 72b of the anode, and an acute angle formed between the tangent line L0 and the top surface 72b is referred to as the taper angle a. When the isolation structure 740 is prepared, a groove structure shown in FIG. 25 is formed. The groove structure may be described by using the following geometric relationship: There is a connection line between a point on the cathode material 750 and a point on the cathode 710, and an acute angle formed between the connection line and the top surface 72b is greater than or equal to the taper angle a. For example, there is a connection line L5, and an acute angle f formed between the connection line L5 and the top surface 72b is greater than the taper angle a. Alternatively, there is a connection line L6 parallel to the tangent line L0, and an acute angle g formed between the connection line L6 and the top surface 72b is equal to the taper angle a.

In this implementation, the isolation structure 740 may partially disconnect the organic connection layer 76 in a physical partition manner, to separate subpixels of different colors in the display panel 7, thereby inplementing a function of reducing horizontal crosstalk. Disposing both the isolation structure 740 and the organic connection layer 76 with a high horizontal square resistance can enhance this function, to avoid horizontal crosstalk.

In this embodiment, as shown in FIG. 22 and FIG. 24, in an x-axis direction, the isolation structure 740 may be located between the adjacent anode 721 and anode 722. This is merely an example. Actually, the isolation structure 740 may be disposed between any two adjacent anodes in some anodes (the anodes are only some of all anodes, and the anodes may be arranged together, or may be arranged dispersedly). Alternatively, the isolation structure 740 may be disposed between any two adjacent anodes in all the anodes in the display panel 7. In this embodiment, such two anodes may be referred to as a first anode and a second anode respectively. The isolation structure 740 is located between the first anode and the second anode. It is easy to understand from the foregoing that both a quantity of first anodes and a quantity of second anodes may be greater than or equal to 1. In this embodiment, there may be one isolation structure 740 or there may be a plurality of side-by-side isolation structures 740 between the first anode and the second anode.

In other words, as shown in FIG. 22 and FIG. 24, the isolation structure 740 may be located between adjacent subpixels, and separate the adjacent subpixels. One subpixel may be defined as all stacked structures from one TFT to a part that is of the CPL 720 and that corresponds to the TFT. For example, one subpixel on a left side of FIG. 22 is all stacked structures from the TFT 711 to a part that is of the CPL 720 and that corresponds to the TFT, including the TFT 711, the anode 721, a part of the hole function layer 74, the light emitting unit 751, a part of the organic connection layer 76, the light emitting unit 771, a part of the organic connection layer 76, ..., the light emitting unit 781, a part of the electron function layer 79, a part of the cathode 710, and a part of the CPL 720.

In this embodiment, the isolation structure 740 may be disposed between any two adjacent subpixels in some subpixels (the subpixels are only some of all subpixels, and the subpixels may be arranged together, or may be arranged dispersedly). Alternatively, the isolation structure 740 may be disposed between any two adjacent subpixels in all the subpixels in the display panel 7. In this embodiment, such two subpixels may be referred to as a first subpixel and a second subpixel respectively. The isolation structure 740 is located between the first subpixel and the second subpixel, and separates the first subpixel from the second subpixel. It is easy to understand from the foregoing that both a quantity of first subpixels and a quantity of second subpixels may be greater than or equal to 1. In this embodiment, there may be one isolation structure 740 or there may be a plurality of side-by-side isolation structures 740 between the first subpixel and the second subpixel.

In this embodiment, when the isolation structure 740 is disposed between only some subpixels, the display panel 7 has a small quantity of isolation structures 740. This can reduce damage to the cathode 710 (for example, 2/3 damage may be reduced), reduce power consumption of the display panel 7, and ensure a display effect of the display panel 7. In addition, it is easy to enable the isolation structure 740 to avoid a direction and a position in which the isolation structure 740 has poor bending reliability. This greatly improves reliability of the display panel 7.

In this embodiment, the isolation structures 740 in the display panel 7 may be all pillar structures or all grooves, or a part of the isolation structures 740 are pillar structures, and another part of the isolation structures 740 are grooves.

In this embodiment, a flat structure may be formed in a region in which no isolation structure 740 is disposed, and the flat structure is applicable to the foregoing geometric descriptions. A partitioned structure may be formed in a region in which the isolation structure 740 is disposed, and the partitioned structure may use the foregoing geometric descriptions of the protrusion structure. Therefore, it may be considered that the solution in Embodiment 7 uses the semi-flat structure + the semi-partitioned structure.

In this embodiment, the isolation structure 740 may be located between a red light subpixel and a green light subpixel, and the isolation structure 740 partitions off the red light subpixel from the green light subpixel; and /or the isolation structure 740 may be located between the red light subpixel and a blue light subpixel, and the isolation structure 740 partitions off the red light subpixel from the blue light subpixel; and/or the isolation structure 740 may be located between the green light subpixel and the blue light subpixel, and the isolation structure 740 partitions off the green light subpixel from the blue light subpixel.

A horizontal crosstalk reduction design in this embodiment may be applied to various pixel arrangement patterns. The pixel arrangement patterns are enumerated below.

FIG. 26 to FIG. 31 each are a diagram of applying the horizontal crosstalk reduction design to a 2B in 1 type arrangement in a real red-green-blue (Real RGB) arrangement according to this embodiment. A ratio of physical pixels to real pixels in the Real RGB arrangement is 1:1. The 2B in 1 arrangement means that two blue light subpixels are evaporated in one FMM hole, and a spacing d1 between the two blue light subpixels is small. "Red", "green", and "blue" respectively represent a red light subpixel, a green light subpixel, and a blue light subpixel.

As shown in FIG. 26, for example, the isolation structure 740 is disposed only between the green light subpixel and the red light subpixel, and partitions off only some adjacent green light subpixels from red light subpixels, rather than partitioning off all adjacent green light subpixels from red light subpixels.

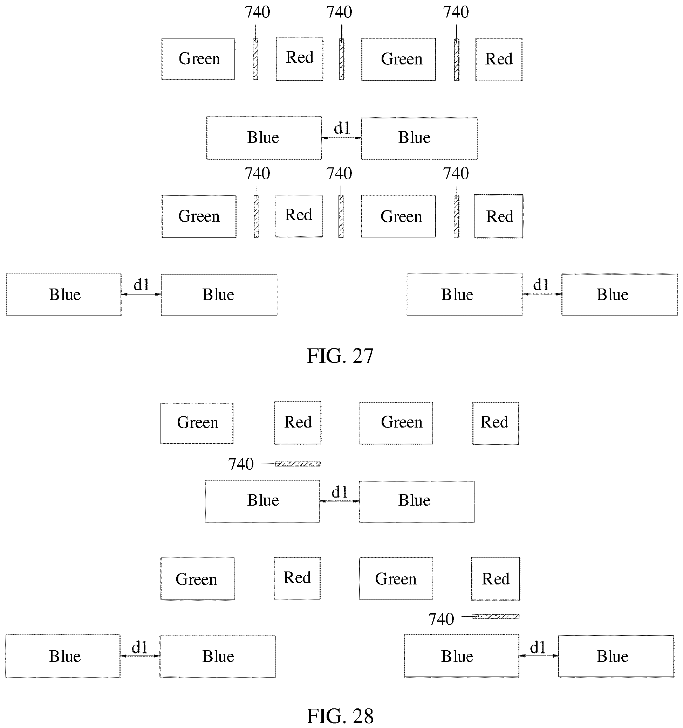

Different from that shown in FIG. 26, as shown in FIG. 27, for example, the isolation structure 740 may be disposed between all adjacent green light subpixels and red light subpixels.

As shown in FIG. 26, for example, the isolation structure 740 is disposed only between the green light subpixel and the red light subpixel, and partitions off only some adjacent green light subpixels from red light subpixels, rather than partitioning off all adjacent green light subpixels from red light subpixels.

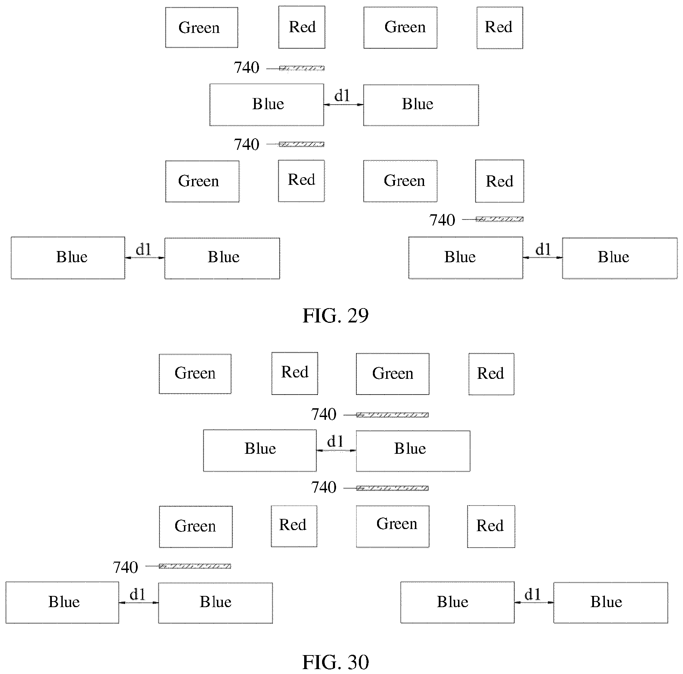

Different from that shown in FIG. 28, as shown in FIG. 29, for example, the isolation structure 740 may be basically disposed between all adjacent red light subpixels and blue light subpixels.

Different from that shown in FIG. 26, as shown in FIG. 30, for example, the isolation structure 740 is disposed only between the green light subpixel and the blue light subpixel, and partitions off only some adjacent green light subpixels from blue light subpixels, rather than partitioning off all adjacent green light subpixels from blue light subpixels.

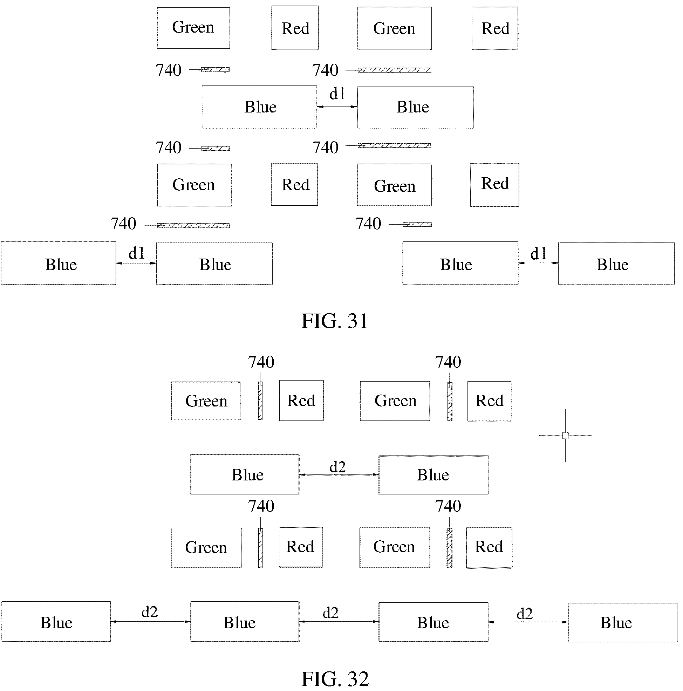

Different from that shown in FIG. 30, as shown in FIG. 31, for example, the isolation structure 740 may be disposed between all adjacent green light subpixels and blue light subpixels.

FIG. 32 to FIG. 37 each are a diagram of applying the horizontal crosstalk reduction design to a 1B in 1 arrangement in the Real RGB pixel arrangement according to this embodiment. The 1B in 1 arrangement means that one blue light subpixel is vaporized in one FMM hole, and a spacing d2 between two adjacent blue light subpixels is large.

As shown in FIG. 32, for example, the isolation structure 740 is disposed only between the green light subpixel and the red light subpixel, and partitions off only some adjacent green light subpixels from red light subpixels, rather than partitioning off all adjacent green light subpixels from red light subpixels.

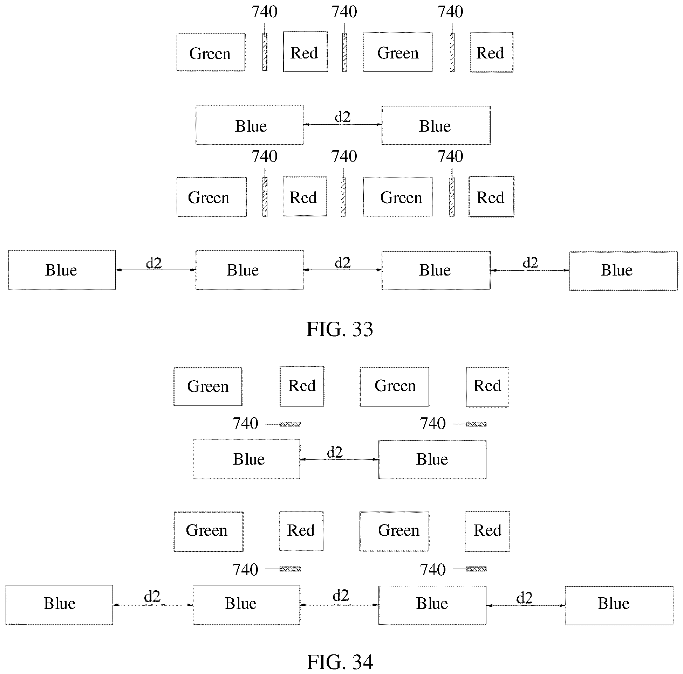

Different from that shown in FIG. 32, as shown in FIG. 33, for example, the isolation structure 740 may be disposed between all adjacent green light subpixels and red light subpixels.

Different from that shown in FIG. 32, as shown in FIG. 34, for example, the isolation structure 740 is disposed only between the red light subpixel and the blue light subpixel, and partitions off only some adjacent red light subpixels from blue light subpixels, rather than partitioning off all adjacent red light subpixels from blue light subpixels.

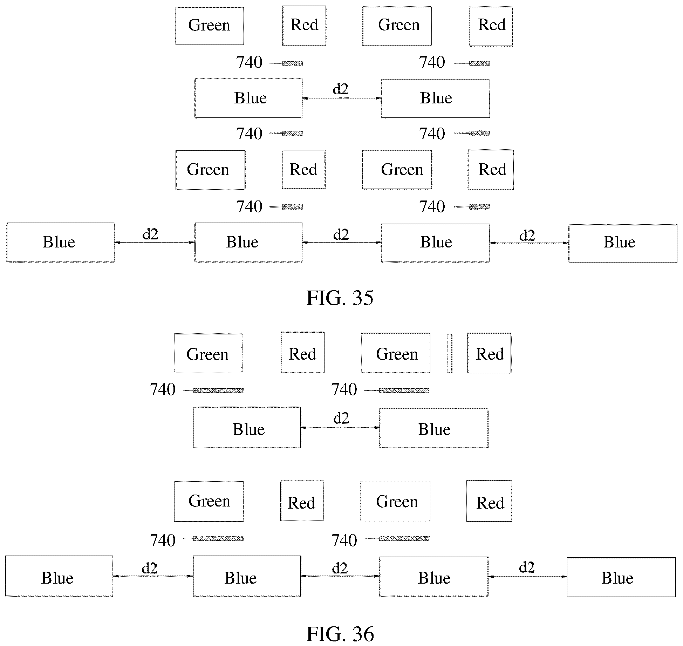

Different from that shown in FIG. 34, as shown in FIG. 35, for example, the isolation structure 740 may be disposed between all adjacent red light subpixels and blue light subpixels.

Different from that shown in FIG. 32, as shown in FIG. 36, for example, the isolation structure 740 is disposed only between the green light subpixel and the blue light subpixel, and partitions off only some adjacent green light subpixels from blue light subpixels, rather than partitioning off all adjacent green light subpixels from blue light subpixels.

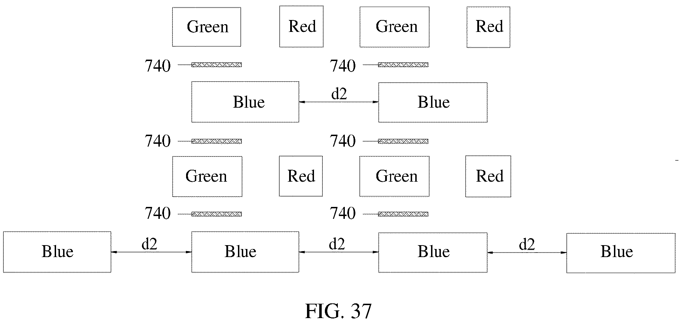

Different from that shown in FIG. 36, as shown in FIG. 37, for example, the isolation structure 740 may be disposed between all adjacent green light subpixels and blue light subpixels.

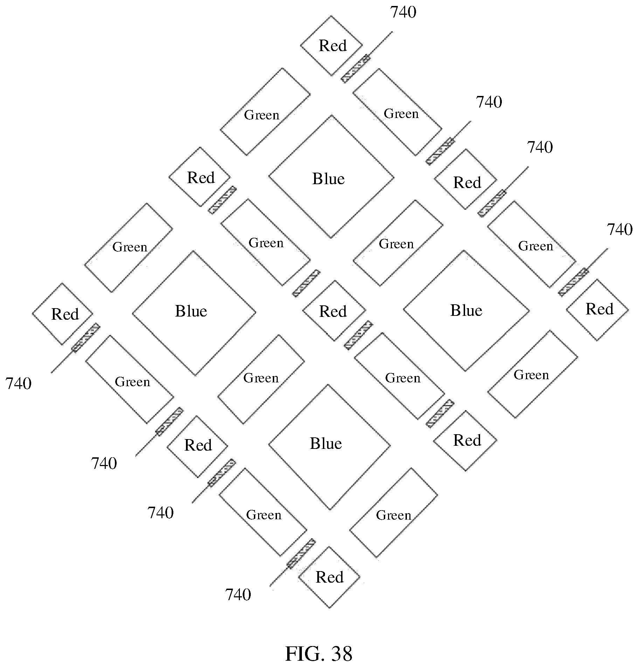

FIG. 38 to FIG. 43 each are a diagram of applying the horizontal crosstalk reduction design to a diamond arrangement according to this embodiment. To keep the figure clear, only a part of the isolation structures 740 is shown.

As shown in FIG. 38, for example, the isolation structure 740 is disposed only between the red light subpixel and the green light subpixel, and partitions off only some adjacent red light subpixels from green light subpixels, rather than partitioning off all adjacent red light subpixels from green light subpixels.

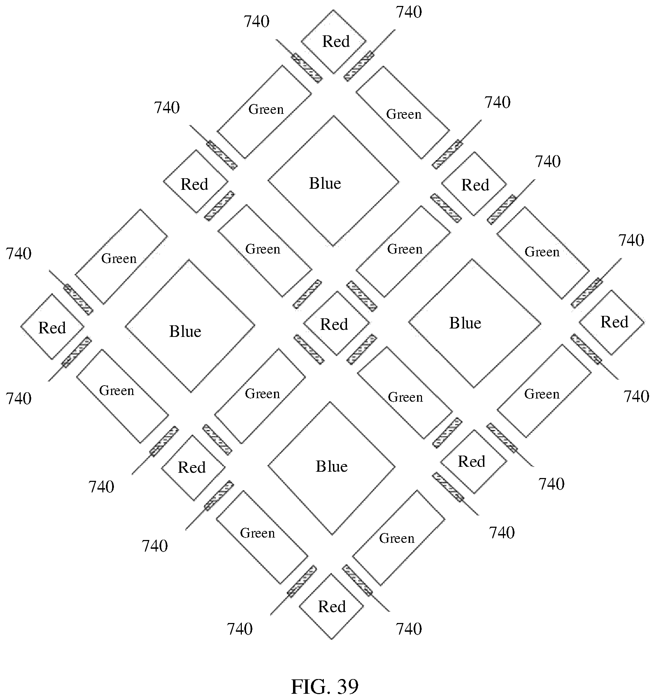

Different from that shown in FIG. 38, as shown in FIG. 39, for example, the isolation structure 740 may be disposed between all adjacent red light subpixels and green light subpixels.

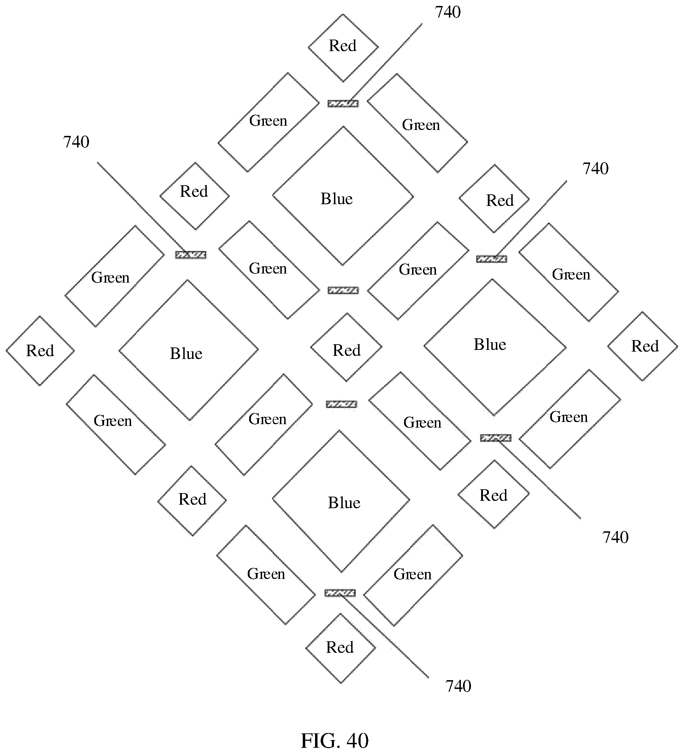

Different from that shown in FIG. 38, as shown in FIG. 40, for example, the isolation structure 740 is disposed only between the red light subpixel and the blue light subpixel, and partitions off only some adjacent red light subpixels from blue light subpixels, rather than partitioning off all adjacent red light subpixels from blue light subpixels.

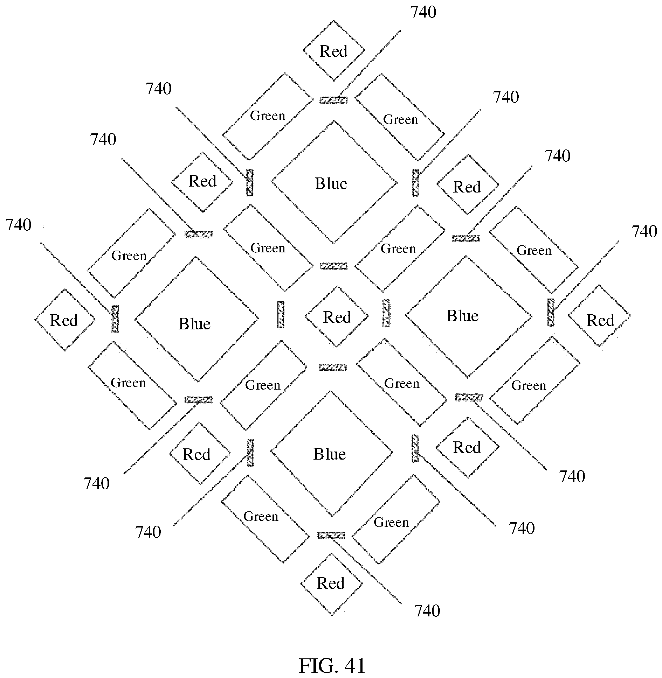

Different from that shown in FIG. 40, as shown in FIG. 41, for example, the isolation structure 740 may be disposed between all adjacent red light subpixels and blue light subpixels.

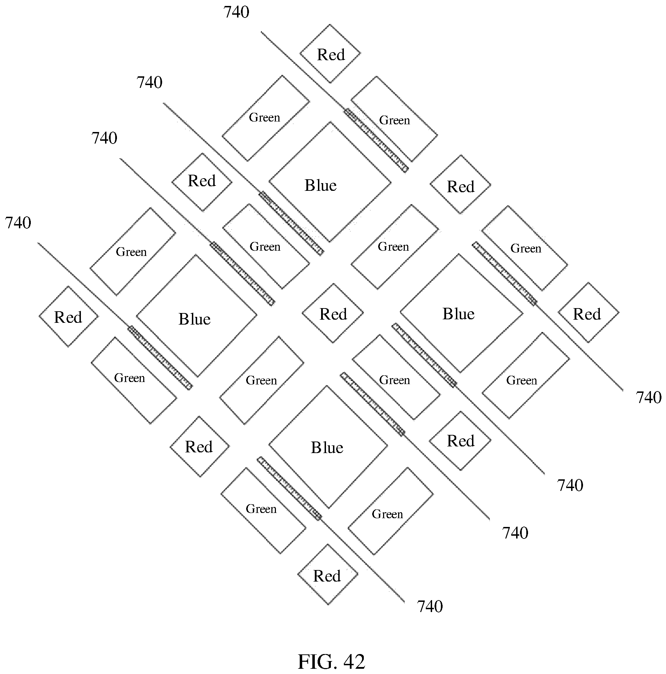

Different from that shown in FIG. 38, as shown in FIG. 42, for example, the isolation structure 740 is disposed only between the green light subpixel and the blue light subpixel, and partitions off only some adjacent green light subpixels from blue light subpixels, rather than partitioning off all adjacent green light subpixels from blue light subpixels.

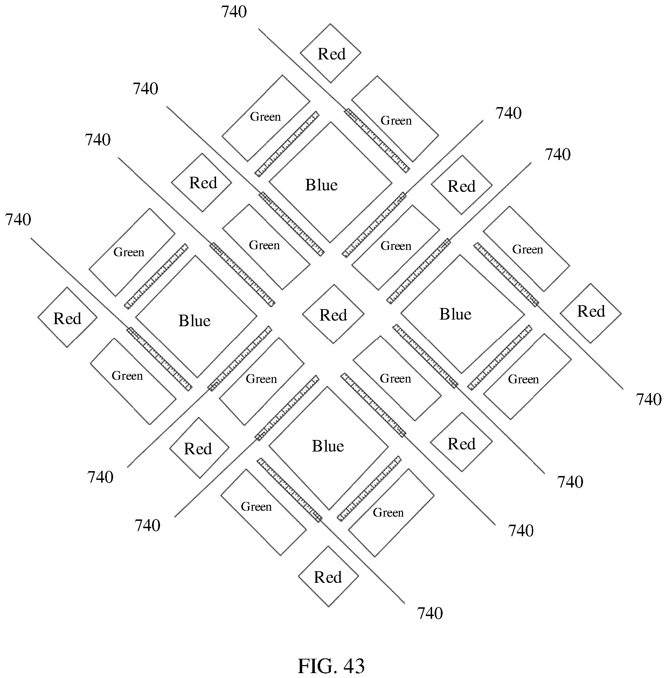

Different from that shown in FIG. 42, as shown in FIG. 43, for example, the isolation structure 740 may be disposed between all adjacent green light subpixels and blue light subpixels.

In addition to the foregoing pixel arrangement patterns, the horizontal crosstalk reduction design in this embodiment may be further applied to any other appropriate pixel arrangement, including but not limited to a Delta arrangement, a tripod arrangement, a PenTile arrangement, and a diamond-like arrangement.

A shape of the subpixel is not limited in this embodiment. For example, the subpixel may be in a regular shape like a rectangle, a rectangle with rounded corners, a circle, or a triangle, or may be in a polygon of any shape or a smooth irregular shape, and the subpixel may be further divided into two or more small blocks that do not emit light continuously. Each small block may be in a rectangle, a rectangle with rounded corners, a circle, a triangle, a polygon of any shape, a smooth irregular shape, or the like.

The pixel arrangements and the subpixel shapes recorded in Embodiment 7 are applicable to any embodiment of this application.

In addition to being applied to the foregoing pixel arrangement patterns, the horizontal crosstalk reduction design in this embodiment may be applied to semi-flat and semi-partitioned tandem OLEDs with different partitioned structure designs, where between two subpixels (or on a PDL gap), there may be a single isolation pillar (which may be referred to as a single pillar), or there may be two isolation pillars (which may be referred to as double pillars) or more than two isolation pillars (which may be referred to as multiple pillars); and there may be a single isolation groove (which may be referred to as a single groove), or there may be two isolation grooves (which may be referred to as double grooves) or more than two isolation grooves (which may be referred to as multiple grooves). A cross-sectional shape of the isolation pillar or the isolation groove may be a rectangle, a regular trapezoid, an inverted trapezoid, or another regular or irregular geometric shape. Structure sizes such as shapes, heights or depths, and widths of different isolation structures on a same PDL gap (or between a same pair of subpixels) may be the same, or may be different.

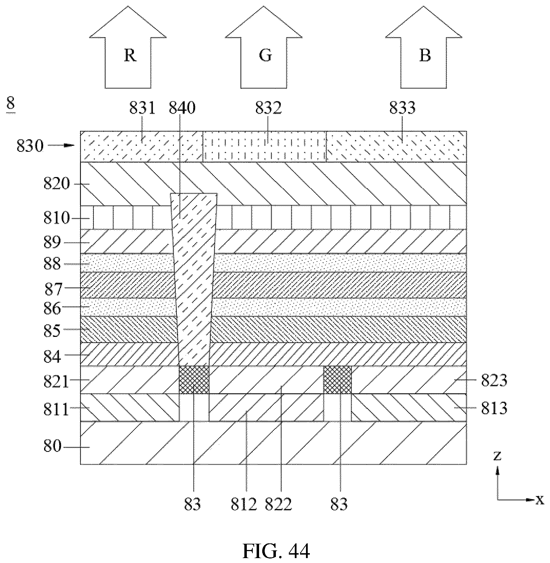

Different from Embodiment 7, a display panel 8 in Embodiment 8 can be colorized in the manner of the white light + the color filter film. FIG. 44 to FIG. 47 are diagrams of partial sectional structures of the display panel 8 in different implementations according to Embodiment 8.

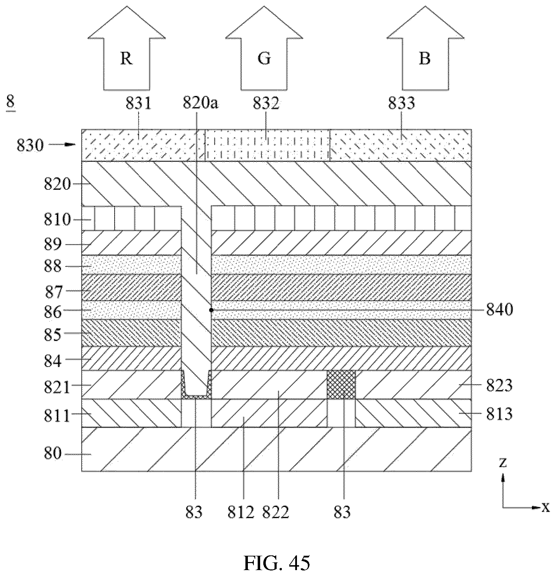

As shown in FIG. 44 and FIG. 45, the display panel 8 may include a substrate 80, a TFT 811, a TFT 812, a TFT 813, an anode 821, an anode 822, an anode 823, a PDL 83, a hole function layer 84, a light emitting layer 85, an organic connection layer 86, a light emitting layer 87, an electron function layer 88, a cathode 89, a CPL 810, an encapsulation layer 820, a first color filter film 830, and an isolation structure 840. The isolation structure 840 in FIG. 44 is a pillar structure, the isolation structure 840 in FIG. 45 is a groove, and a part 820a of the encapsulation layer 820 may be filled in the groove and cover the PDL 83.

Same as Embodiment 7, the display panel 8 in Embodiment 8 also uses the organic connection layer 86 with a semi-flat structure + a semi-partition structure + a high square resistance. The isolation structure separates subpixels of different colors in the display panel 8.

Different from Embodiment 7, as shown in FIG. 44 and FIG. 45, both the light emitting layer 85 and the light emitting layer 87 are horizontally continuous organic material layers, and deposition of the light emitting layer 85 or the light emitting layer 87 can be completed through one time of vapor deposition by using a CMM process without using an FMM process. The light emitting layer 85 and the light emitting layer 87 may emit light of different colors, and the light of the light emitting layer 85 and the light of the light emitting layer 87 can be mixed into white light. For example, the light emitting layer 85 may include a red light emitting unit (R) and a green light emitting unit (G). Red light emitted by the red light emitting unit (R) and green light emitted by the green light emitting unit (G) may be mixed into yellow light. Therefore, the light emitting layer 85 can emit yellow light. For example, the light emitting layer 87 may include a blue light emitting unit (B), and the light emitting layer 87 can emit blue light. The yellow light emitted by the light emitting layer 85 and the blue light emitted by the light emitting layer 87 may be mixed into white light, and finally all the light emitting layers emit the white light as a whole.

As shown in FIG. 44 and FIG. 45, the first color filter film 830 may be formed on the encapsulation layer 820. The first color filter film 830 may include a plurality of first red light filter units 831, a plurality of first green light filter units 832, and a plurality of first blue light filter units 833. The first red light filter units 831, the first green light filter units 832, and the first blue light filter units 833 may be arranged in an array according to a specific rule. It may be understood that the first red light filter unit 831, the first green light filter unit 832, and the first blue light filter unit 833 are sequentially arranged along an x-axis. This is merely an example. Actually, an arrangement pattern of the light filter units may be determined based on a pixel arrangement pattern, and is not limited in Embodiment 8.

Refer to FIG. 44 and FIG. 45. The white light emitted by the light emitting layers as a whole may be transmitted upward and separately enter the first red light filter unit 831, the first green light filter unit 832, and the first blue light filter unit 833. The first red light filter unit 831 filters the white light and emits red light, the first green light filter unit 832 filters the white light and emits green light, and the first blue light filter unit 833 filters the white light and emits blue light, to implement color display of the display panel 8.

The display panel 8 in Embodiment 8 may use a top-emitting architecture, and light is transmitted upward and emitted from the first color filter film 830 on the encapsulation layer 820. In another embodiment, the display panel 8 may use a bottom-emitting architecture, the first color filter film 830 is located below the substrate 80 (that is, located on a side that is of the substrate 80 and that faces away from the light emitting layer), and light is transmitted downward and emitted from the first color filter film 830 below the substrate 80.

In Embodiment 8, colorization is implemented by using a manner of the white light + the color filter film. This helps improve PPI of the display panel. For example, the display panel 8 in Embodiment 8 is applicable to an electronic device like a silicon-based OLED television or an OLED television.

In another embodiment, based on a requirement, colorization may be implemented in the manner of the white light + the color filter film by using another white light OLED device structure.

For example, in Embodiment 9, refer to FIG. 44 or FIG. 45. The light emitting layer 85 may include a blue light emitting unit (B), and the light emitting layer 85 can emit blue light. The light emitting layer 87 may include a red light emitting unit (R) and a green light emitting unit (G), and the light emitting layer 87 can emit yellow light. The blue light emitted by the light emitting layer 85 and the yellow light emitted by the light emitting layer 87 may be mixed into white light, and finally all the light emitting layers emit the white light as a whole.

Alternatively, in Embodiment 10, a red light emitting layer, a green light emitting layer, and a blue light emitting layer may be separately disposed, the three light emitting layers are stacked (not limited to being sequentially stacked), and any two light emitting layers are connected in series through one organic connection layer. Red light emitted by the red light emitting layer, green light emitted by the green light emitting layer, and blue light emitted by the blue light emitting layer are mixed into white light, and finally all the light emitting layers emit the white light as a whole.

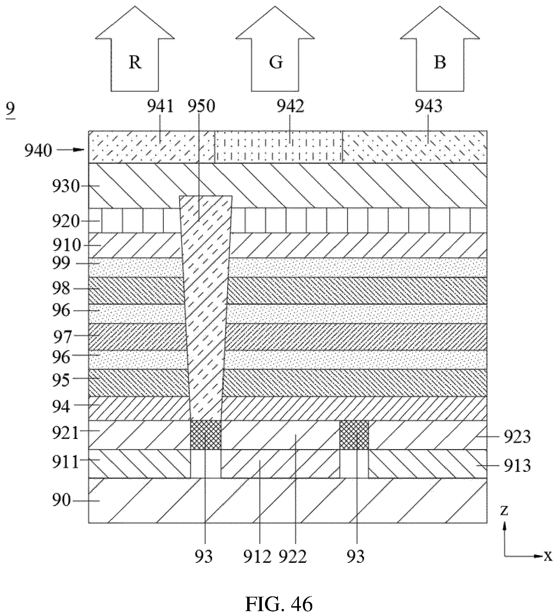

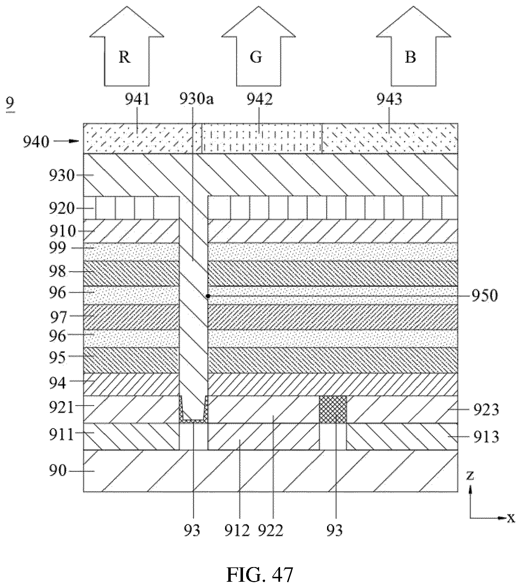

Alternatively, in Embodiment 11 shown in FIG. 46 and FIG. 47, two light emitting layers emitting blue light and one light emitting layer emitting yellow light may be disposed, and white light is obtained by mixing the blue light and the yellow light.

As shown in FIG. 46 and FIG. 47, a display panel 9 in Embodiment 11 may include a substrate 90, a TFT 911, a TFT 912, a TFT 913, an anode 921, an anode 922, an anode 923, a PDL 93, a hole function layer 94, a light emitting layer 95, an organic connection layer 96, a light emitting layer 97, an organic connection layer 96, a light emitting layer 98, an electron function layer 99, a cathode 910, a CPL 920, an encapsulation layer 930, a first color filter film 940, and an isolation structure 950. The isolation structure 950 in FIG. 46 is a pillar structure, the isolation structure 950 in FIG. 47 is a groove, and a part 930a of the encapsulation layer 930 may be filled in the groove and cover the PDL 93. The first color filter film 940 may include a plurality of first red light filter units 941, a plurality of first green light filter units 942, and a plurality of first blue light filter units 943.

As shown in FIG. 46 and FIG. 47, the light emitting layer 95 may include a blue light emitting unit (B), and the light emitting layer 95 may emit blue light. The light emitting layer 97 may include a red light emitting unit (R) and a green light emitting unit (G), and the light emitting layer 97 may emit yellow light. The light emitting layer 98 may include a blue light emitting unit (B), and the light emitting layer 98 may emit blue light. Finally, all the light emitting layers emit white light as a whole. It may be understood that an arrangement sequence of the light emitting layer 95-the light emitting layer 97-the light emitting layer 98 is merely an example. Actually, an arrangement sequence of the light emitting layers may be set based on a requirement, and is not limited in Embodiment 11.

In the tandem OLED, efficiency of emitting blue light by the organic light emitting layer is low, and it is difficult to emit blue light. Therefore, in Embodiment 11, a light emitting layer that emits blue light is additionally disposed, so that light output efficiency of blue light can be improved.

Alternatively, in another embodiment, a first light emitting layer and a second light emitting layer may be separately disposed, and the first light emitting layer and the second light emitting layer are stacked. The first light emitting layer may include a red light emitting unit (R), and the first light emitting layer may emit red light. The second light emitting layer may include a green light emitting unit (G) and a blue light emitting unit (B), and the second light emitting layer may emit cyan light. Finally, all the light emitting layers emit white light as a whole.

Alternatively, in another embodiment, a first light emitting layer and a second light emitting layer may be separately disposed, and the first light emitting layer and the second light emitting layer are stacked. The first light emitting layer may include a green light emitting unit (G), and the first light emitting layer may emit green light. The second light emitting layer may include a red light emitting unit (R) and a blue light emitting unit (B), and the second light emitting layer may emit red light. Finally, all the light emitting layers emit white light as a whole.

It may be understood that only some white light OLED device structures are described above. In embodiments of this application, different white light OLED device structures may be disposed based on a requirement. These white light OLED device structures meet the following design. In a plurality of light emitting layers, at least two light emitting layers may separately emit light of different colors, and light emitted by all the light emitting layers may be mixed into white light. Finally, all the light emitting layers emit the white light as a whole.

Different from the foregoing embodiment in which colorization is implemented in the manner of the white light + the color filter film, in Embodiment 12, colorization may be implemented by using blue light + a color change layer.

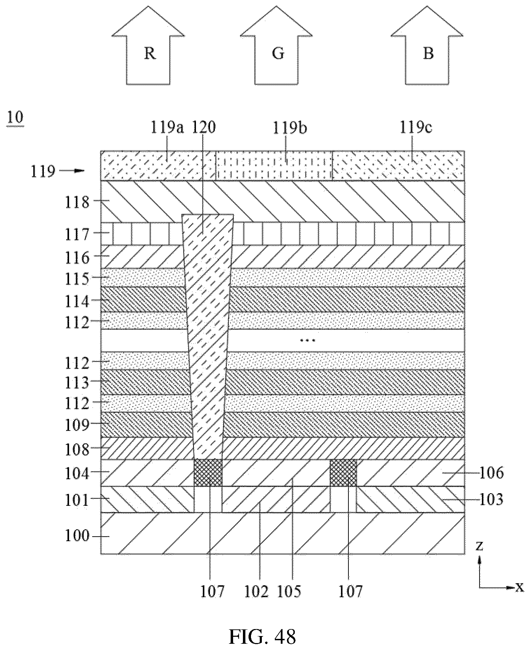

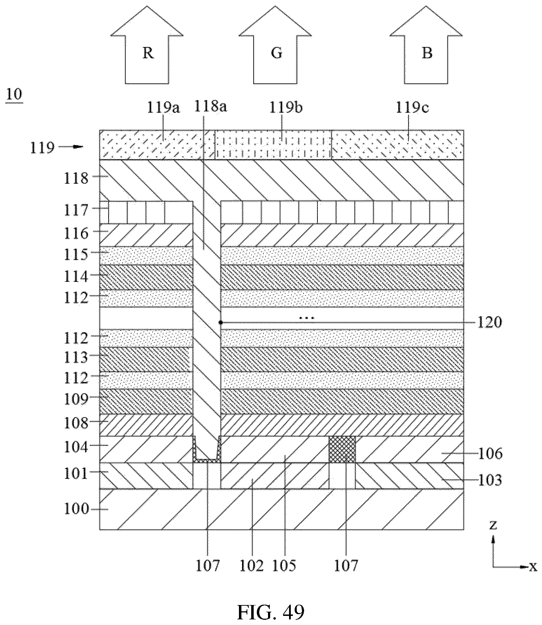

FIG. 48 and FIG. 49 are diagrams of partial sectional structures of a display panel 10 according to Embodiment 12. As shown in FIG. 48 and FIG. 49, the display panel 10 may include a substrate 100, a TFT 101, a TFT 102, a TFT 103, an anode 104, an anode 105, an anode 106, a PDL 107, a hole function layer 108, a light emitting layer 109, an organic connection layer 112, a light emitting layer 113, a light emitting layer 114, an electron function layer 115, a cathode 116, a CPL 117, an encapsulation layer 118, a color change layer 119, and an isolation structure 120. The isolation structure 120 in FIG. 48 is a pillar structure, the isolation structure 120 in FIG. 49 is a groove, and a part 118a of the encapsulation layer 118 may be filled in the groove and cover the PDL 107. The light emitting layer 109, the light emitting layer 113, and the light emitting layer 114 are sequentially stacked, and two adjacent light emitting layers are connected in series through one organic connection layer 112. The light emitting layer 109, the light emitting layer 113, and the light emitting layer 114 each include a blue light emitting unit (B), and the light emitting layer 109, the light emitting layer 113, and the light emitting layer 114 each can emit blue light. Finally, all the light emitting layers emit blue light as a whole.

As shown in FIG. 48 and FIG. 49, the color change layer 119 may be formed on the encapsulation layer 118. The color change layer 119 may include a plurality of red light conversion units 119a, a plurality of green light conversion units 119b, and a plurality of blue light conversion units 119c. The red light conversion units 119a, the green light conversion units 119b, and the blue light conversion units 119c may be arranged in an array according to a specific rule. It may be understood that the red light conversion unit 119a, the green light conversion unit 119b, and the blue light conversion unit 119c are sequentially arranged along an x-axis. This is merely an example. Actually, an arrangement pattern of the conversion units may be determined based on a pixel arrangement pattern, and is not limited in Embodiment 12.

As shown in FIG. 48 and FIG. 49, the blue light emitted by the light emitting layers as a whole may be transmitted upward and separately enter the red light conversion unit 119a, the green light conversion unit 119b, and the blue light conversion unit 119c. The red light conversion unit 119a may perform color conversion on the blue light and emit red light, the green light conversion unit 119b may perform color conversion on blue light and emit green light, and the blue light conversion unit 119c may narrow a spectrum of the blue light and emit purer blue light, to implement color display of the display panel 10.

The display panel 10 in Embodiment 12 may use a top-emitting architecture, and light is transmitted upward and emitted from the color change layer 119 on the encapsulation layer 118. In another embodiment, the display panel 10 may use a bottom-emitting architecture, the color change layer 119 is located below the substrate 100 (that is, located on a side that is of the substrate 100 and that faces away from the light emitting layer), and light is transmitted downward and emitted from the color change layer 119 below the substrate 100.

In Embodiment 12, for example, to ensure pure light color of the display panel 6, a second color filter film may be further disposed outside the color change layer 119. The second color filter film may be located on a side that is of the color change layer 119 and that is away from the encapsulation layer 118 (the top-emitting architecture), or located on a side that is of the color change layer 119 and that is away from the substrate 100 (the bottom-emitting architecture). The second color filter film may include a plurality of second red light filter units, a plurality of second green light filter units, and a plurality of second blue light filter units. The second red light filter unit corresponds to the red light conversion unit. The second red light filter unit may filter the red light emitted by the red light conversion unit and emit red light, the second green light filter unit may filter the green light emitted by the green light conversion unit and emit green light, and the second blue light filter unit may filter the blue light emitted by the blue light conversion unit and emit blue light.

In Embodiment 12, colorization is implemented in the manner of blue light + the color change layer. This helps simplify a process, reduce a voltage drop, reduce power consumption of the display panel, and improve luminance of the display panel. For example, the display panel 10 in Embodiment 12 is applicable to an electronic device like a high-luminance television.

Different from Embodiment 12, in another embodiment, the color change layer may not include the blue light conversion unit, the second color filter film may include the second blue light filter unit, and the second blue light filter unit filters the blue light emitted by the light emitting layers.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A display panel, comprising:
a plurality of anodes, a pixel definition layer, a hole function layer, a plurality of light emitting layers, at least one organic connection layer, an electron function layer, and a cathode, wherein any two adjacent anodes in the plurality of anodes are isolated by the pixel definition layer, the plurality of anodes, the hole function layer, the plurality of light emitting layers, the electron function layer, and the cathode are sequentially stacked, and each organic connection layer is connected between two adjacent light emitting layers, wherein
a material of each organic connection layer comprises a host material and a doped material doped in the host material, a square resistance of each organic connection layer in any horizontal direction is greater than or equal to 1 GΩ/□, and the any horizontal direction is perpendicular to a thickness direction of the organic connection layer.

2. The display panel according to claim 1, wherein
the organic connection layer comprises a charge generation layer, the charge generation layer comprises an N-type charge generation layer and a P-type charge generation layer, and the P-type charge generation layer is stacked with the N-type charge generation layer, and is located on a side that is of the N-type charge generation layer and that faces the cathode.

3. The display panel according to claim 2, wherein
a host material of the N-type charge generation layer comprises an N-type host material, a doped material of the N-type charge generation layer comprises an N-type doped material, and a concentration of the N-type doped material ∈ (0%, 100%].

4. The display panel according to claim 3, wherein
the N-type host material comprises an organic aromatic material; and/or
the N-type doped material comprises a metal material whose work function is less than or equal to 3.5 eV, or a metal oxide material whose work function is less than or equal to 3.5 eV, or an organic material whose work function is less than or equal to 3.5 eV, or an organic-metal coordination compound material whose work function is less than or equal to 3.5 eV.

5. The display panel according to any one of claims 2 to 4, wherein
a host material of the P-type charge generation layer comprises a P-type host material, a doped material of the P-type charge generation layer comprises a P-type doped material, and a concentration of the P-type doped material ∈ (0%, 100%].

6. The display panel according to claim 5, wherein
the P-type host material comprises an organic aromatic material; and/or
the P-type doped material comprises an organic material whose lowest unoccupied molecular orbital energy level is less than or equal to -3.0 eV, or an inorganic material whose work function is greater than or equal to 3.0 eV.

7. The display panel according to any one of claims 2 to 6, wherein
the charge generation layer further comprises an interlayer, and the interlayer is connected between the N-type charge generation layer and the P-type charge generation layer.

8. The display panel according to any one of claims 2 to 7, wherein
the organic connection layer further comprises at least one of a hole blocking layer, an electron transport layer, a hole injection layer, and a hole transport layer, wherein
the hole blocking layer, the N-type charge generation layer, and the P-type charge generation layer are sequentially stacked;
the electron transport layer, the N-type charge generation layer, and the P-type charge generation layer are sequentially stacked, and when the hole blocking layer exists, the hole blocking layer, the electron transport layer, and the N-type charge generation layer are sequentially stacked;
the hole injection layer is stacked with the P-type charge generation layer, and is located on a side that is of the P-type charge generation layer and that faces the cathode; and
the hole transport layer is stacked with the P-type charge generation layer, and is located on the side that is of the P-type charge generation layer and that faces the cathode, and when the hole injection layer exists, the P-type charge generation layer, the hole injection layer, and the hole transport layer are sequentially stacked.

9. The display panel according to any one of claims 1 to 8, wherein
a longitudinal mobility of the organic connection layer is 10⁻¹ cm²/(V·S) to 10⁻⁶ cm²/(V·S).

10. The display panel according to any one of claims 1 to 9, wherein
a thickness of each organic connection layer is less than or equal to 300 nm.

11. The display panel according to any one of claims 1 to 10, wherein
the plurality of anodes comprise a first anode and a second anode, the first anode is adjacent to the second anode, and the first anode has a top surface facing the cathode; and a part that is of the pixel definition layer and that is located between the first anode and the second anode has a taper angle; and
an acute angle formed between the top surface and a connection line between any two points on a surface that is of the cathode and that faces the pixel definition layer is less than or equal to the taper angle, and an acute angle formed between the top surface and a connection line between any two points on a surface that is of the cathode and that faces away from the pixel definition layer is less than or equal to the taper angle.

12. The display panel according to any one of claims 1 to 10, wherein
\the display panel further comprises an isolation structure, the isolation structure is formed on the pixel definition layer, and the isolation structure penetrates the hole function layer, the plurality of light emitting layers, the at least one organic connection layer, the electron function layer, and the cathode.

13. The display panel according to claim 12, wherein
the display panel comprises a plurality of subpixels, some of the plurality of subpixels comprise a first subpixel and a second subpixel, the first subpixel is adjacent to the second subpixel, and the isolation structure is located between the first subpixel and the second subpixel.

14. The display panel according to claim 12 or 13, wherein
the isolation structure comprises a pillar structure.

15. The display panel according to any one of claims 12 to 14, wherein
the isolation structure comprises a groove, and a side that is of the pixel definition layer and that faces away from the cathode is a bottom wall of the groove.

16. The display panel according to any one of claims 1 to 15, wherein
the subpixels in the display panel form a real red-green-blue arrangement, a diamond arrangement, a Delta arrangement, a tripod arrangement, a PenTile arrangement, or a diamondlike arrangement.

17. The display panel according to any one of claims 1 to 16, wherein
each light emitting layer comprises a red light emitting unit, a green light emitting unit, and a blue light emitting unit.

18. The display panel according to any one of claims 1 to 16, wherein
the display panel comprises a first color filter film, the first color filter film comprises a plurality of first red light filter units, a plurality of first green light filter units, and a plurality of first blue light filter units, and the first color filter film is located on a side that is of the cathode and that faces away from the electron function layer, or the first color filter film is located on a side that is of the plurality of anodes and that faces away from the hole function layer; and
at least two of the plurality of light emitting layers are respectively configured to emit light of different colors, and the plurality of light emitting layers emit white light as a whole; and the first red light filter unit is configured to filter the white light and emit red light, the first green light filter unit is configured to filter the white light and emit green light, and the first blue light filter unit is configured to filter the white light and emit blue light.

19. The display panel according to any one of claims 1 to 16, wherein
the display panel comprises a color change layer, the color change layer comprises a plurality of red light conversion units and a plurality of green light conversion units, and the color change layer is located on a side that is of the cathode and that faces away from the electron function layer, or the color change layer is located on a side that is of the plurality of anodes and that faces away from the hole function layer; and
each of the plurality of light emitting layers is configured to emit blue light, the red light conversion unit is configured to perform color conversion on the blue light and emit red light, and the green light conversion unit is configured to perform color conversion on the blue light and emit green light.

20. The display panel according to claim 19, wherein
the display panel further comprises a second color filter film, the second color filter film is located on a side that is of the color change layer and that faces away from the cathode, the second color filter film comprises a plurality of second red light filter units, a plurality of second green light filter units, and a plurality of second blue light filter units, the second red light filter unit is configured to filter the red light emitted by the red light conversion unit and emit red light, the second green light filter unit is configured to filter the green light emitted by the green light conversion unit and emit green light, and the second blue light filter unit is configured to filter the blue light and emit blue light.

21. The display panel according to any one of claims 1 to 20, wherein
the display panel further comprises a substrate, a plurality of thin film transistors, a capping layer, and an encapsulation layer, the plurality of thin film transistors are disposed on a side that is of the substrate and that faces the plurality of anodes, and the plurality of thin film transistors are electrically connected to the plurality of anodes in a one-to-one manner, the capping layer is located on the side that is of the cathode and that faces away from the electron function layer, and the encapsulation layer is located on a side that is of the capping layer and that faces away from the cathode;
the first color filter film is located on a side that is of the encapsulation layer and that faces away from the capping layer, or is located on a side that is of the substrate and that faces away from the plurality of thin film transistors;
the color change layer is located on the side that is of the encapsulation layer and that faces away from the capping layer, or is located on the side that is of the substrate and that faces away from the plurality of thin film transistors; and
a part of the encapsulation layer is filled in the groove and covers the pixel definition layer.

22. A display, comprising:
a cover and the display panel according to any one of claims 1 to 21, wherein the cover is attached to the display panel.

23. An electronic device, comprising:
a mechanical part and the display according to claim 22, wherein the display is fastened to the mechanical part.
